# EUROPEAN PATENT SPECIFICATION

(11) **EP 4 186 693 B1**
(45) Date of publication and mention of the grant of the patent: **26.02.2025**
(21) Application number: 21852372.8
(22) Date of filing: 31.05.2021
(51) Int. Cl.: B32B 15/18, C25D 7/00, H05K 9/00

(54) **HOUSING STRUCTURE, PREPARATION METHOD THEREFOR, AND ELECTRONIC DEVICE**
GEHÄUSESTRUKTUR, HERSTELLUNGSVERFAHREN DAFÜR UND ELEKTRONISCHE VORRICHTUNG
STRUCTURE DE LOGEMENT, SON PROCÉDÉ DE PRÉPARATION, ET DISPOSITIF ÉLECTRONIQUE

(30) Priority: 05.08.2020 CN 202010780225
(43) Date of publication of application: 31.05.2023
(73) Proprietor: Huawei Technologies Co., Ltd., Shenzhen, Guangdong 518129 (CN)
(72) Inventor: CAO, Zhiyu, Shenzhen, Guangdong 518129 (CN); CAI, Ming, Shenzhen, Guangdong 518129 (CN); ZHONG, Huiting, Shenzhen, Guangdong 518129 (CN)
(74) Representative: Grünecker Patent- und Rechtsanwälte PartG mbB
(86) International application number: PCT/CN2021/097266
(87) International publication number: WO 2022/028072

(56) References cited:
- CN-U- 208 841 989
- CN-U- 213 108 528
- KR-A- 20170 142 625
- US-A- 4 647 714
- US-A1- 2010 098 890
- US-A1- 2010 098 920
- US-A1- 2013 029 071

## Description

### TECHNICAL FIELD

This application relates to the technical field of structural materials, and in particular, to a housing structure, a production method thereof, and an electronic device.

### BACKGROUND

As a market requires a low weight, a small thickness, and an aesthetic appeal of a notebook product, comprehensive requirements on aspects such as density, strength, and a surface processing manner of a housing material of the notebook product are increasingly high. These specifications and performance requirements are often contradictory. For example, density of a magnesium alloy and a carbon fiber may be lighter than density of an aluminum alloy. However, surface processing manners of the magnesium alloy and the carbon fiber are undiversified, and therefore a metallic appearance with an aesthetic appeal effect similar to that of the aluminum alloy after anodic oxidation processing is performed on the aluminum alloy cannot be achieved.
US 2013/0029071 A1 discloses a metal casing comprising a metal substrate, a thermoplastic rubber adhesive layer and plastic parts formed on the thermoplastic rubber adhesive layer and a decorative outer layer. KR 1020170142625 A discloses an aluminum pouch comprising an aluminum layer, an external resin layer formed on one side of the aluminum layer, an internal resin layer formed on the other side of the aluminum layer, a first adhesive layer formed between the aluminum layer and the external resin layer, and between the aluminum layer and the internal resin layer and also a chemical conversion layer. US 4647714 A1 discloses a composite sheet material used for shielding magnetism and electromagnetic waves, principally made of an electrodeposited iron foil, as the core, with a thickness of at least 10 mu m which is applied on either side surface thereof a plating layer with a respectively predetermined metal, and of, a covering layer which is formed of a suitable sheet-like material and which is to be laminated on at least one of the two plating layers through the medium of an adhesive layer. CN 208841989 U discloses a composite mobile phone casing wherein a back plate and/or side plates of the housing are composed of two layers of composite plates, the outer layer of which is a metal plate, and the inner layer of which is a non-metallic plate.

### SUMMARY

This application provides a housing structure, a production method thereof, and an electronic device, so that the housing structure has comprehensive advantages of a metal layer housing and a non-metal layer housing.

According to a first aspect, a housing structure is provided. The housing structure includes an appearance effect layer, a metal layer, a connection layer, and a non-metal layer that are laminated. The connection layer is configured to bind the metal layer and the non-metal layer. The appearance effect layer is formed after surface processing is performed on the metal layer. The housing structure includes both the metal layer and the non-metal layer. The metal layer and the non-metal layer are bound by using the connection layer, so that the housing structure has comprehensive advantages of a metal layer housing and a non-metal layer housing. In addition, the appearance effect layer formed after surface processing is performed on the metal layer can ensure that the housing structure has a metallic appearance with an aesthetic appeal.

In this application, the non-metal layer is mainly used to reduce overall density of the housing structure and provide strength support for the housing structure. Therefore, a material of the non-metal layer needs to have characteristics such as low density, high strength, and easy molding. Optionally, the material of the non-metal layer includes at least one of a carbon fiber composite material, a glass fiber composite material, engineering plastic, and an inorganic fiber composite material.

Further, the non-metal layer may be formed by using a molding process or an in-mold decoration process, and a thickness of the non-metal layer may be set to 60% to 80% of a total thickness of the housing structure. Therefore, the housing structure can have advantages of low density, high strength, an aesthetic appeal, and metallic quality, so that product competitiveness is greatly improved.

Optionally, the glass fiber composite material may include a glass fiber resin composite material.

Further, when the glass fiber composite material includes glass fiber (GF) that accounts for 30% and polyphenylene sulfide (PPS) that accounts for 70%, an electromagnetic shielding function of the housing structure can be improved.

Optionally, the engineering plastic may usually include a polycarbonate (PC), a complex of a polycarbonate (PC) and glass fiber (GF), a complex of a polycarbonate (PC) and a terpolymer (ABS), a complex of polystyrene (PG) and polyphenylene sulfide (PPS), or the like.

In this application, the appearance effect layer is formed after surface processing is performed on the metal layer, and the appearance effect layer is mainly used to improve an aesthetic appeal effect of the housing structure. Optionally, a surface processing manner may be anodic oxidation processing, coloring micro-arc oxidation processing, physical vapor deposition (Physical Vapor Deposition, PVD) coating processing, electrophoresis processing, nano stamping, or the like. This is not limited herein. Appearance effect layers formed in different surface processing manners further have other performance such as a protective property, an insulation property, and an improved binding force with an organic or inorganic coating. Specific performance is related to the surface processing manner, and details are not described herein. The appearance effect layer is formed after surface processing is performed on the metal layer. Therefore, a proportion of a thickness of the appearance effect layer to the total thickness of the housing structure may be ignored.

In this application, the metal layer is mainly disposed to form the appearance effect layer, and a material of the metal layer may be any metal thin-walled material that has metallic quality and on which surface processing can be performed. For example, the material of the metal layer may include at least one of a magnesium alloy, an aluminum alloy, a titanium alloy, steel, and an amorphous alloy. When the material of the metal layer is steel, stainless steel may be selected.

Optionally, to make a weight of the housing structure as small as possible, a thickness of the metal layer may be set to any value provided that surface processing can be performed to form the appearance effect layer. During specific implementation, the thickness of the metal layer usually occupies 15% to 30% of the total thickness of the housing structure.

In this application, the connection layer is used to bind the metal layer and non-metal layer, and a total thickness of the connection layer usually occupies 2% to 20% of the total thickness of the housing structure.

Further, the connection layer includes a first connection layer and a second connection layer, the first connection layer is located on a side close to the metal layer, and the second connection layer is located on a side close to the non-metal layer. In other words, the metal layer and the non-metal layer are bound by using two connection layers.

Furthermore, a binding force of a material of the first connection layer and the metal layer is greater than a binding force of a material of the second connection layer and the metal layer, and a binding force of the material of the second connection layer and the non-metal layer is greater than a binding force of the material of the first connection layer and the non-metal layer. In other words, a material with a relatively large binding force on the metal layer is selected for the first connection layer, and a material with a relatively large binding force on the non-metal layer is selected for the second connection layer, so that a coefficient of thermal expansion gradient between the metal layer and the non-metal layer is reduced, and a binding force of the metal layer and the non-metal layer is increased.

To prevent the binding force of the metal layer and the non-metal layer from being affected because a large quantity of bubbles are generated when the metal layer and the non-metal layer are bound by using the first connection layer and the second connection layer, the material of the first connection layer further needs to have relatively good wettability for the metal layer. Therefore, a material that can enable a contact area proportion of the first connection layer and the metal layer to be greater than or equal to 90% needs to be selected for the first connection layer. Similarly, the material of the second connection layer further needs to have relatively good wettability for the non-metal layer. Therefore, a material that can enable a contact area proportion of the second connection layer and the non-metal layer to be greater than or equal to 90% needs to be selected for the second connection layer.

Optionally, in this application, the first connection layer may include a first glue layer, and the second connection layer may include a second glue layer. Therefore, the binding force of the metal layer and the non-metal layer is increased by using two glue layers. Further, materials of the first glue layer and the second glue layer may be the same or different.

In a specific feasible solution, the materials of the first glue layer and the second glue layer are different, a material of the first glue layer is glue with relatively strong affinity and a relatively large binding force on metal, for example, epoxy resin glue and a material of the second glue layer is glue with relatively strong affinity and a relatively large binding force on non-metal, for example, polyurethane glue. Therefore, the binding force of the metal layer and the non-metal layer is greatly increased, and a coefficient of thermal expansion (CTE) gradient is reduced, so that a housing structure with a complex structural form can be molded, and a deformation degree of the housing structure can be well controlled.

In a specific feasible solution, the first connection layer may include a solder layer, the second connection layer may include an electroplated coating, and the electroplated coating is formed by electroplating metal on the non-metal layer. In other words, the solder layer and the electroplated coating are used as intermediate connection layers between the metal layer and the non-metal layer, so that the metal layer and the non-metal layer are bound through soldering. A CTE gradient of the housing structure is greatly reduced, so that a housing structure with a complex structural form can be molded, and a deformation degree of the housing structure can be well controlled. In addition, the binding force of the metal layer and the non-metal layer can be relatively stable by using a soldering technology, and long-term stability is greatly improved, so that stamping molding processing requirement in a subsequent process can be met, to be specific, a raw material manufacturer and a processing manufacturer can be independent of each other, and intermediate storage time efficiency is greatly improved.

During specific implementation, a material of the electroplated coating may include at least one of tin, chromium, nickel, silver, and copper. A material of the solder layer may be a low-temperature solder such as a tin-based solder. For environmental protection, the material of the solder layer may be a lead-free tin-based solder.

In a specific feasible solution, the first connection layer may include a micro-nano porous layer, and the micro-nano porous layer is formed after micro-nano pore etching processing is performed on the metal layer. The second connection layer may include a glue layer. Therefore, the metal layer and the non-metal layer are bound by using the micro-nano porous layer and the glue layer. In comparison with a conventional gluing process, the micro-nano porous layer can greatly increase a binding force of metal and non-metal.

Optionally, a material of the glue layer may be formed by mixing two types of resin glue based on a specific proportion, for example, AB resin glue.

In a specific feasible solution, the first connection layer may include a micro-nano porous layer, and the micro-nano porous layer is formed after micro-nano pore etching processing is performed on the metal layer. The second connection layer may include a surface pore filling layer, and a material of the surface pore filling layer is the same as the material of the non-metal layer. The surface pore filling layer may be formed by using an injection molding process or a heat-processing inlaying process, so that the surface pore filling layer and the non-metal layer can be simultaneously formed. Finally, the non-metal layer and the metal layer are directly combined together by using the micro-nano porous layer and the injection molding process or the heat-processing inlaying process, to reduce intermediate processes and achieve a better economic effect, so that the housing structure can be mass-producible and commercially available to applied products in terms of processes.

In a specific feasible solution, the first connection layer may include a micro-nano porous layer, and the micro-nano porous layer is formed after micro-nano pore etching processing is performed on the metal layer. The second connection layer may include a surface pore filling layer, and a material of the surface pore filling layer is the same as the material of the non-metal layer. The connection layer further includes a third connection layer. The third connection layer is located between the surface pore filling layer and the non-metal layer, and a material of the third connection layer is glue. In other words, the metal layer and the non-metal layer are bound by using the micro-nano porous layer, the surface pore filling layer, and the glue layer.

According to a second aspect, this application provides an electronic device, including a circuit board and the housing structure in any one of the foregoing technical solutions of this application. The housing structure is located on an outer side of the circuit board. Because the housing structure has the technical effects in the first aspect, the electronic device including the housing structure also has comprehensive advantages of a metal layer housing and a non-metal layer housing, and has a metallic appearance with an aesthetic appeal.

### BRIEF DESCRIPTION OF DRAWINGS

FIG. 1 is a schematic diagram of a structure of a housing structure according to an embodiment of this application;
FIG. 2 is a schematic flowchart of a production method for a housing structure according to an embodiment of this application;
FIG. 3 is a schematic diagram of a structure of another housing structure according to an embodiment of this application;
FIG. 4 is a schematic diagram of a structure of another housing structure according to an embodiment of this application;
FIG. 5 is a schematic flowchart of another production method for a housing structure according to an embodiment of this application;
FIG. 6 is a schematic diagram of a process route corresponding to a housing structure according to an embodiment of this application;
FIG. 7 is a schematic flowchart of still another production method for a housing structure according to an embodiment of this application;
FIG. 8 is a schematic diagram of another process route corresponding to a housing structure according to an embodiment of this application;
FIG. 9 is a schematic flowchart of still another production method for a housing structure according to an embodiment of this application;
FIG. 10 is another schematic diagram of a structure of a housing structure according to an embodiment shape of the target housing. For example, when the surface processing process is a PVD coating process, a temperature is relatively high, and the non-metal layer is just a material, for example, a carbon fiber composite material, that is not resistant to a high temperature.

Optionally, in this application, the enabling, by using a connection layer, a metal layer and a non-metal layer to be bound and to form a laminated structure with a shape of a target housing specifically includes: enabling, by using a first connection layer and a second connection layer, the metal layer and the non-metal layer to be bound and to form the laminated structure with the shape of the target housing. In other words, the metal layer and the non-metal layer are bound by using two connection layers.

In a specific feasible solution, the enabling, by using a first connection layer and a second connection layer, the metal layer and the non-metal layer to be bound and to form the laminated structure with the shape of the target housing specifically includes: coating a first glue layer on a side that is of the metal layer and that faces the non-metal layer, and coating a second glue layer on a side that is of the non-metal layer and that faces the metal layer; and performing stamping processing on the metal layer on which the first glue layer is formed and the non-metal layer on which the second glue layer is formed, to form the laminated structure with the shape of the target housing. Therefore, a binding force of the metal layer and the non-metal layer is greatly increased, and a coefficient of thermal expansion (CTE) gradient is reduced, so that a housing structure with a complex structural form can be molded, and a deformation degree of the housing structure can be well controlled. The metal layer and the non-metal layer are combined through gluing, stamping molding is performed by using good elongation of the metal layer and the glue layer, and further, the metal layer and the glue layer are bound to a surface of the non-metal layer, so that the housing structure can be mass-producible and commercially available to applied products in terms of processes.

In the foregoing implementation solution, to avoid damage to the appearance effect layer that is caused by the housing structure when the shape of the target housing is formed, the step of performing surface processing on the surface on the side that is of the metal layer and that is away from the non-metal layer, to form the appearance effect layer of the housing structure is usually performed after the step of performing stamping processing on the metal layer on which the first glue layer is formed and the non-metal layer on which the second glue layer is formed, to form the laminated structure with the shape of the target housing. However, when the appearance effect layer is formed, if a surface processing process affects performance of the non-metal layer, the step of performing surface processing on the surface on the side that is of the metal layer and that is away from the non-metal layer, to form the appearance effect layer of the housing structure needs to be performed before the step of performing stamping processing on the metal layer on which the first glue layer is formed and the non-metal layer on which the second glue layer is formed, to form the laminated structure with the shape of the target housing. For example, when the surface processing process is a PVD coating process, a temperature is relatively high, and the non-metal layer is just a material, for example, a carbon fiber composite material, that is not resistant to a high temperature.

Further, when the step of performing surface processing on the surface on the side that is of the metal layer and that is away from the non-metal layer, to form the appearance effect layer of the housing structure is performed before the step of performing stamping processing on the metal layer on which the first glue layer is formed and the non-metal layer on which the second glue layer is formed, to form the laminated structure with the shape of the target housing, to prevent a product yield from being affected because damage is caused to the appearance effect layer when the metal layer is molded, in this application, before surface processing is performed on the surface on the side that is of the metal layer and that is away from the non-metal layer, to form the appearance effect layer, the method further includes: performing stamping processing on the metal layer, so that the metal layer has an initial shape of the target housing. In other words, after the metal layer has the initial shape of the target housing, the appearance effect layer is formed on the surface of the metal layer.

In a specific feasible solution, the enabling, by using a first connection layer and a second connection layer, the metal layer and the non-metal layer to be bound and to form the laminated structure with the shape of the target housing specifically includes: performing micro-nano pore etching processing on a side that is of the metal layer and that faces the non-metal layer, to form a micro-nano porous layer, and attaching a glue layer on the side that is of the metal layer and that faces the non-metal layer; and performing stamping processing on the metal layer on which the micro-nano porous layer is formed and the non-metal layer on which the glue layer is attached, to form the laminated structure with the shape of the target housing. Therefore, the metal layer and the non-metal layer are bound by using the micro-nano porous layer and the glue layer. In comparison with a conventional gluing process, the micro-nano porous layer can greatly increase a binding force of metal and non-metal.

Optionally, in the foregoing implementation solution, to avoid damage to the appearance effect layer that is caused by the housing structure when the shape of the target housing is formed, after the laminated structure is formed, surface processing is performed on the surface on the side that is of the metal layer and that is away from the non-metal layer, to form the appearance effect layer.

In a specific feasible solution, the enabling, by using a connection layer, a metal layer and a non-metal layer to be bound and to form a laminated structure with a shape of a target housing specifically includes: forming, by using an electroplating process, an electroplated coating on a side that is of the metal layer and that faces the non-metal layer; forming a solder layer between the metal layer and the electroplated coating, and performing soldering processing, so that the metal layer and the non-metal layer are bound by using the solder layer and the electroplated coating; and performing stamping processing on the metal layer and the non-metal layer that are bound, to form the laminated structure with the shape of the target housing. In other words, the solder layer and the electroplated coating are used as intermediate connection layers between the metal layer and the non-metal layer, so that the metal layer and the non-metal layer are bound through soldering. A CTE gradient of the formed housing structure is greatly reduced, so that a housing structure with a complex structural form can be molded, and a deformation degree of the housing structure can be well controlled. In addition, the binding force of the metal layer and the non-metal layer can be relatively stable by using a soldering technology, and long-term stability is greatly improved, so that stamping molding processing stamping molding processing in a subsequent in a subsequent process can be met, to be specific, a raw material manufacturer and a processing manufacturer can be independent of each other, and intermediate storage time efficiency is greatly improved.

Optionally, in the foregoing implementation solution, to avoid damage to the appearance effect layer that is caused by the housing structure when the shape of the target housing is formed, after the laminated structure is formed, surface processing is performed on the surface on the side that is of the metal layer and that is away from the non-metal layer, to form the appearance effect layer.

In a specific feasible solution, the enabling, by using a connection layer, a metal layer and a non-metal layer to be bound and to form a laminated structure with a shape of a target housing specifically includes: forming the metal layer with an initial shape of the target housing; performing micro-nano pore etching processing on a side that is of the metal layer and that faces the non-metal layer, to form a micro-nano porous layer; and injecting a non-metal material into the micro-nano porous layer by using an injection molding process, to form a surface pore filling layer, and forming the non-metal layer on a side that is of the surface pore filling layer and that is away from the metal layer, to obtain the laminated structure with the shape of the target housing; or inlaying a non-metal material into the micro-nano porous layer by using a heat-processing inlaying process, to form a surface pore filling layer, and forming the non-metal layer on a side that is of the surface pore filling layer and that is away from the metal layer, to obtain the laminated structure with the shape of the target housing. Finally, the non-metal layer and the metal layer are directly combined together by using the micro-nano porous layer and the injection molding process or the heat-processing inlaying process, to reduce intermediate processes and achieve a better economic effect, so that the housing structure can be mass-producible and commercially available to applied products in terms of processes.

Optionally, in the foregoing implementation solution, to avoid damage to the appearance effect layer that is caused by the housing structure when the shape of the target housing is formed, after the laminated structure is formed, surface processing is performed on the surface on the side that is of the metal layer and that is away from the non-metal layer, to form the appearance effect layer.

According to a fourth aspect, this application provides a housing structure. The housing structure is formed by using the production method in any one of the foregoing technical solutions of this application. The housing structure has comprehensive advantages of a metal layer housing and a non-metal layer housing. In addition, an appearance effect layer formed after surface processing is performed on a metal layer can ensure that the housing structure has a metallic appearance with an aesthetic appeal.

According to a fifth aspect, this application provides an electronic device, including a circuit board and the housing structure in any one of the foregoing technical solutions of this application. The housing structure is located on an outer side of the circuit board. Because the housing structure has the technical effects in the fourth aspect, the electronic device including the housing structure also has comprehensive advantages of a metal layer housing and a non-metal layer housing, and has a metallic appearance with an aesthetic appeal.

### BRIEF DESCRIPTION OF DRAWINGS

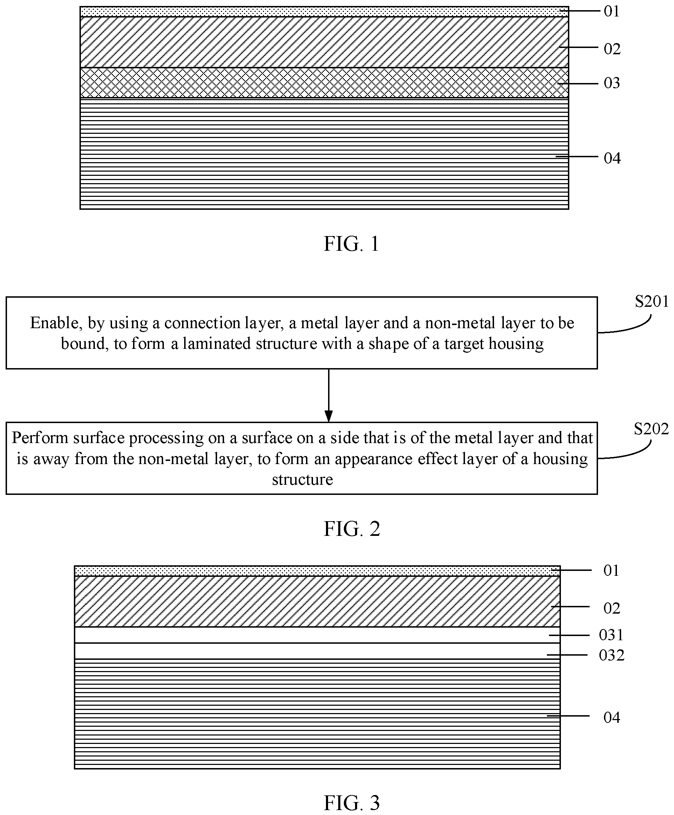

FIG. 1 is a schematic diagram of a structure of a housing structure according to an embodiment of this application;
FIG. 2 is a schematic flowchart of a production method for a housing structure according to an embodiment of this application;
FIG. 3 is a schematic diagram of a structure of another housing structure according to an embodiment of this application;

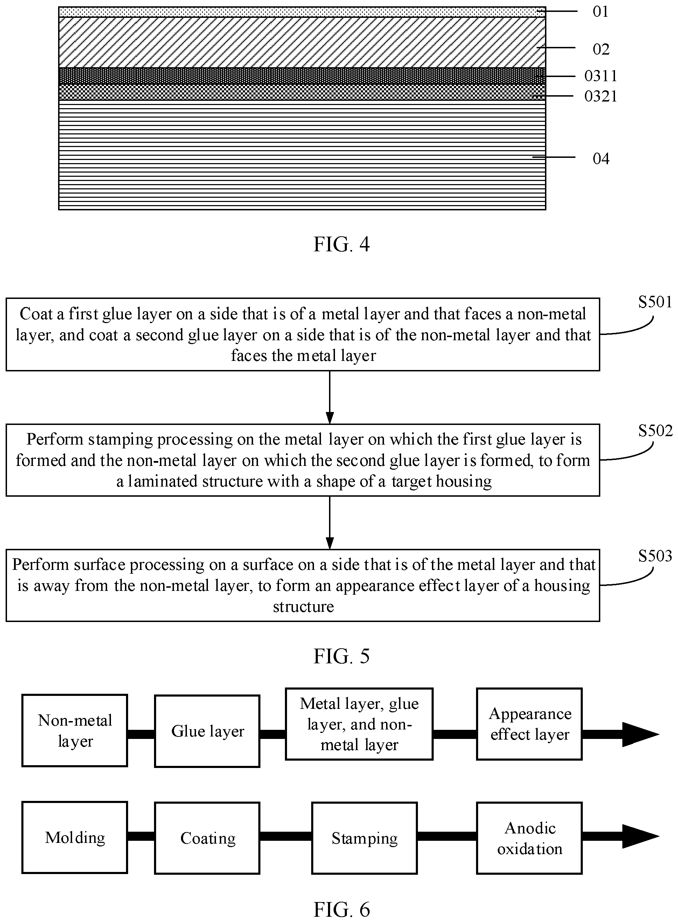

FIG. 4 is a schematic diagram of a structure of another housing structure according to an embodiment of this application;
FIG. 5 is a schematic flowchart of another production method for a housing structure according to an embodiment of this application;
FIG. 6 is a schematic diagram of a process route corresponding to a housing structure according to an embodiment of this application;

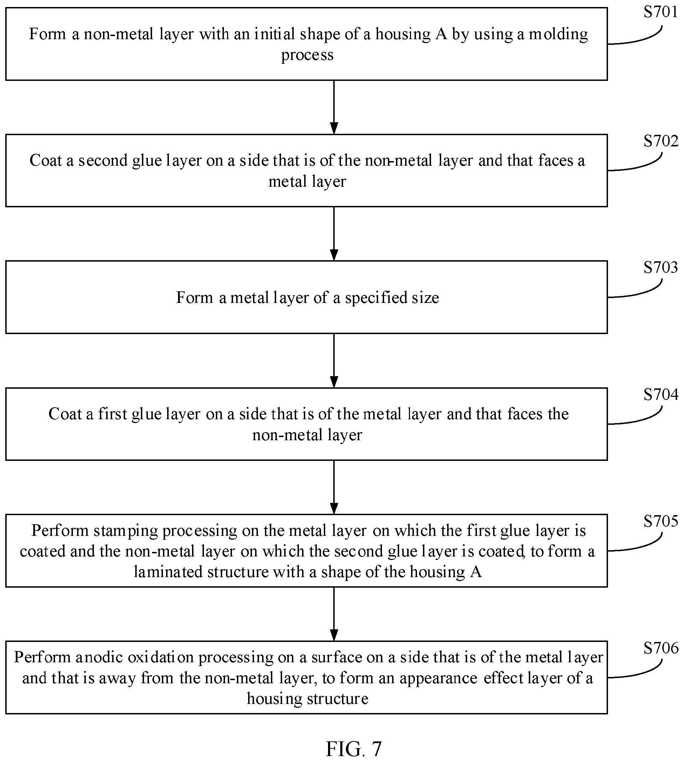

FIG. 7 is a schematic flowchart of still another production method for a housing structure according to an embodiment of this application;

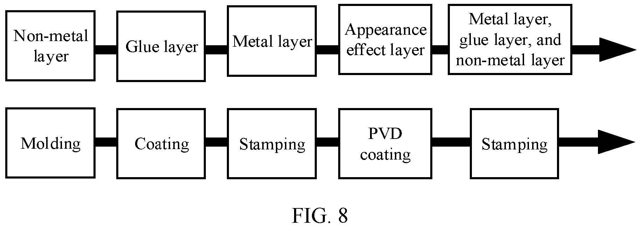

FIG. 8 is a schematic diagram of another process route corresponding to a housing structure according to an embodiment of this application;

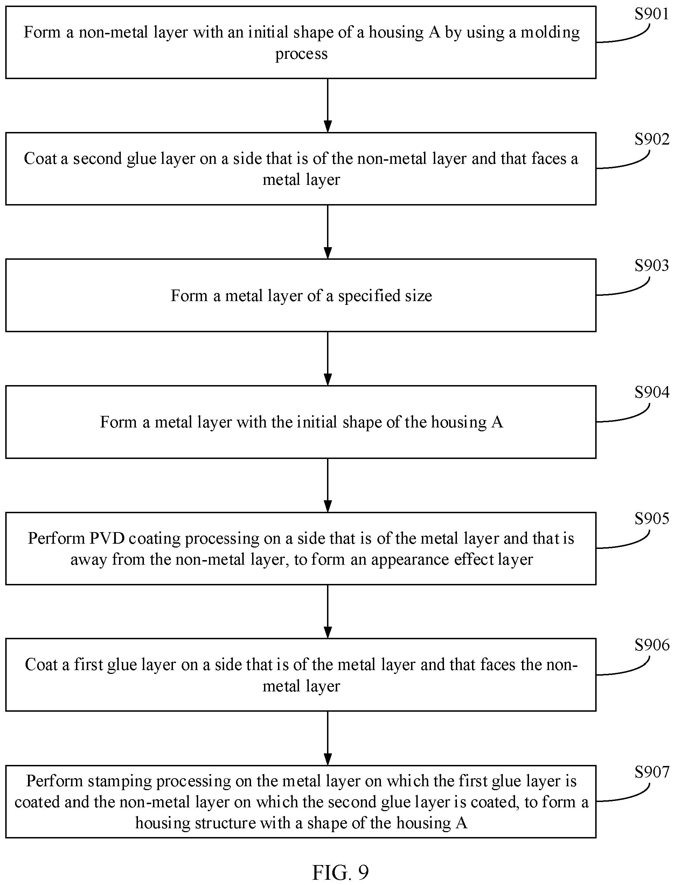

FIG. 9 is a schematic flowchart of still another production method for a housing structure according to an embodiment of this application;

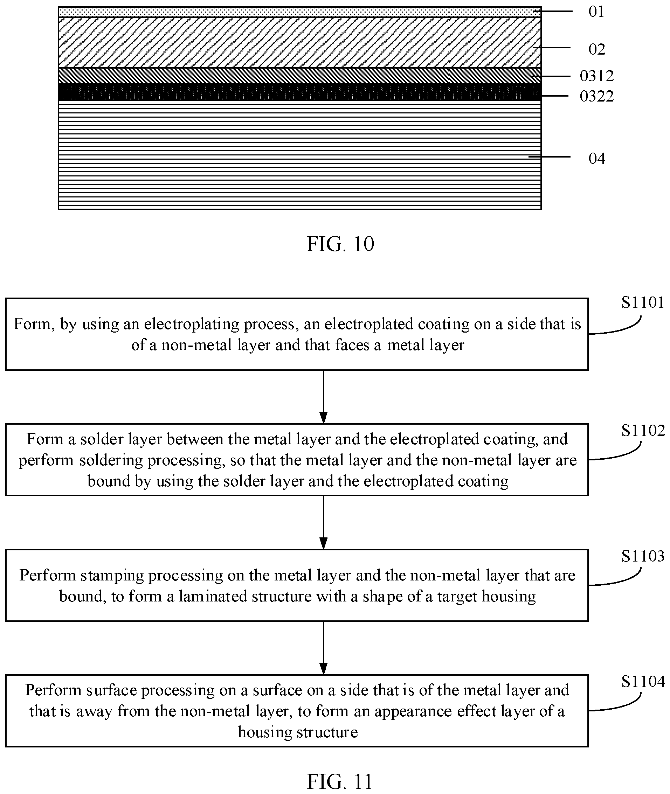

FIG. 10 is another schematic diagram of a structure of a housing structure according to an embodiment of this application;
FIG. 11 is another schematic flowchart of a production method for a housing structure according to an embodiment of this application;

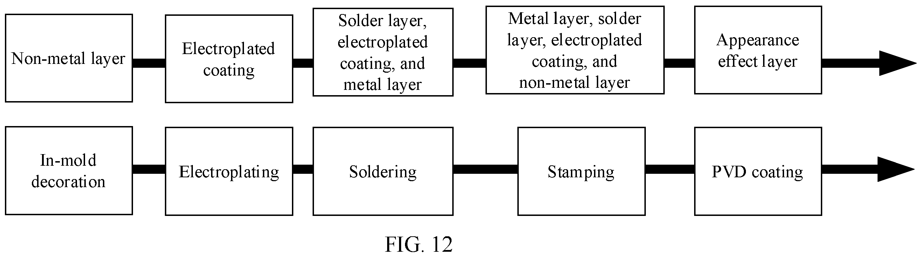

FIG. 12 is a schematic diagram of still another process route corresponding to a housing structure according to an embodiment of this application;

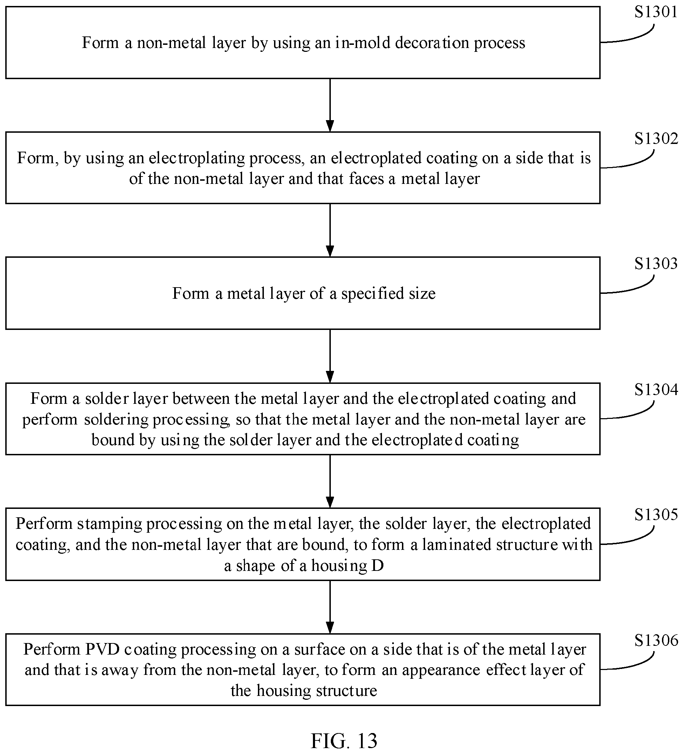

FIG. 13 is still another schematic flowchart of a production method for a housing structure according to an embodiment of this application;

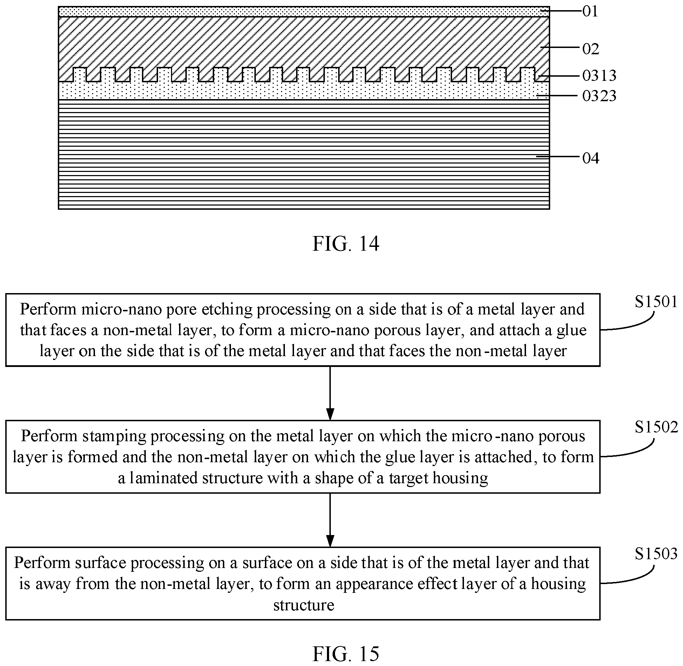

FIG. 14 is still another schematic diagram of a structure of a housing structure according to an embodiment of this application;
FIG. 15 is another schematic flowchart of a production method for a housing structure according to an embodiment of this application;

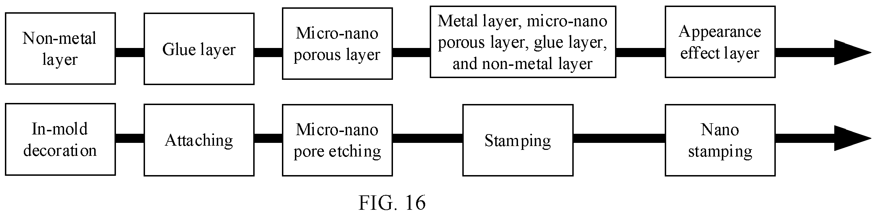

FIG. 16 is a schematic diagram of still another process route corresponding to a housing structure according to an embodiment of this application;

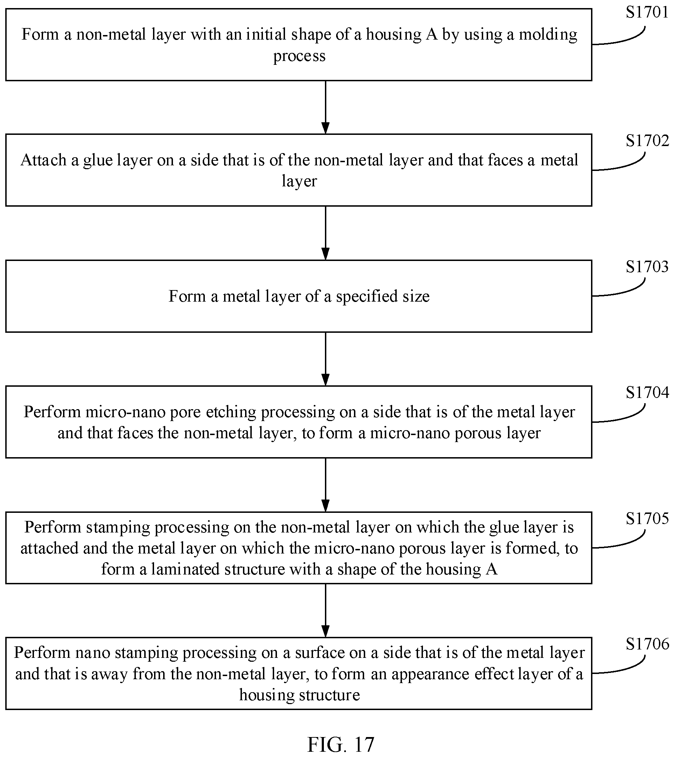

FIG. 17 is still another schematic flowchart of a production method for a housing structure according to an embodiment of this application;

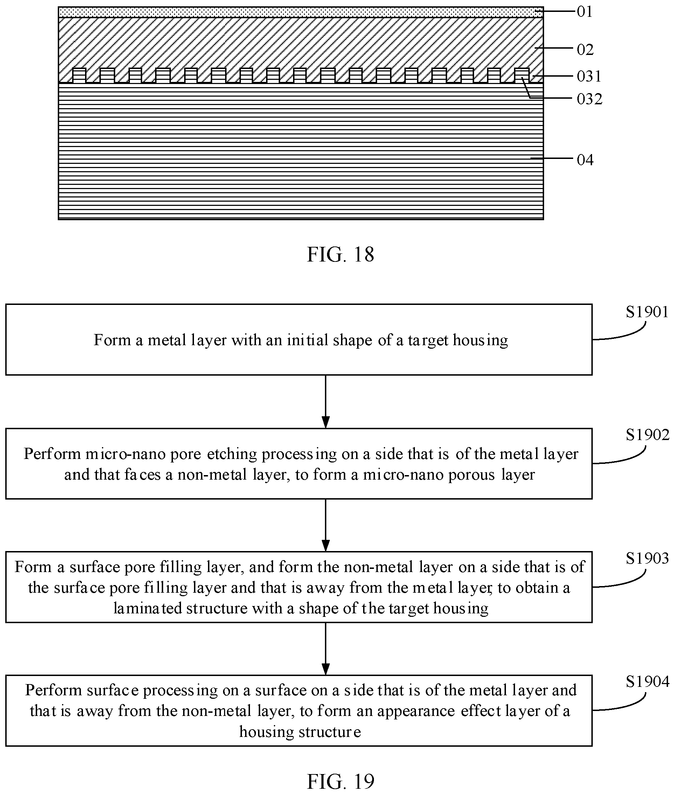

FIG. 18 is still another schematic diagram of a structure of a housing structure according to an embodiment of this application;
FIG. 19 is another schematic flowchart of a production method for a housing structure according to an embodiment of this application;

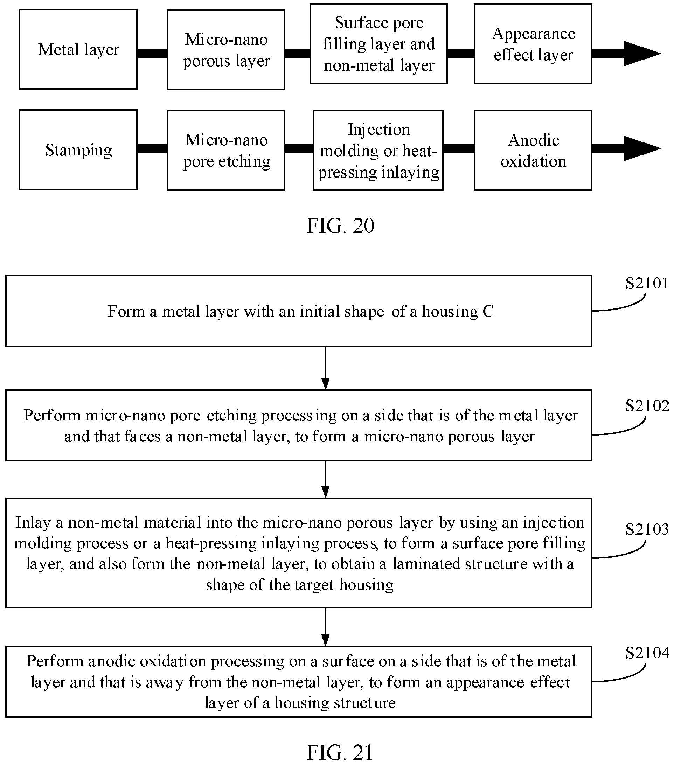

FIG. 20 is a schematic diagram of still another process route corresponding to a housing structure according to an embodiment of this application;
FIG. 21 is still another schematic flowchart of a production method for a housing structure according to an embodiment of this application;

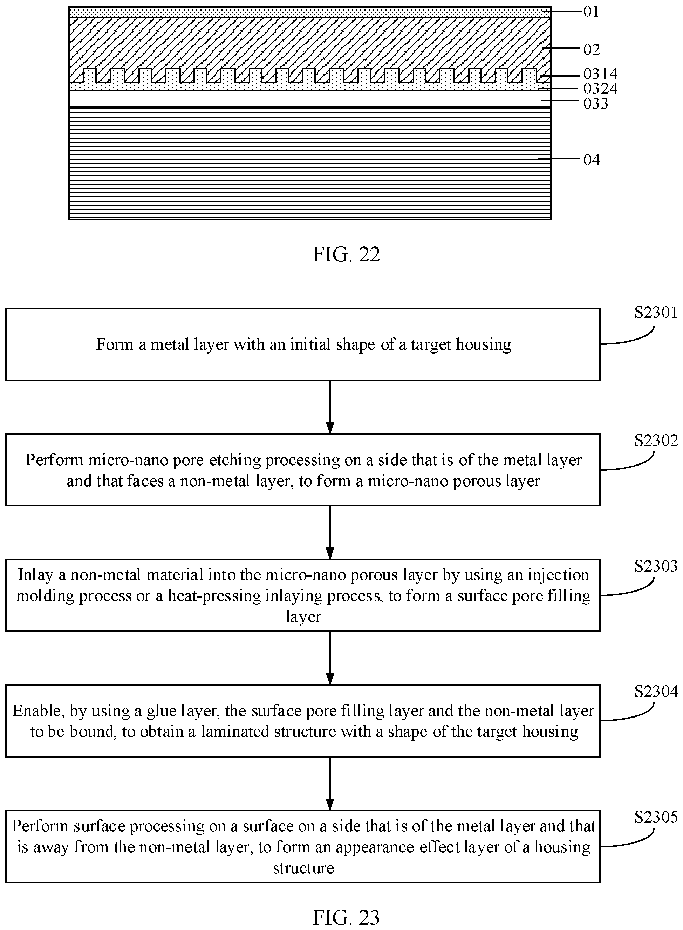

FIG. 22 is still another schematic diagram of a structure of a housing structure according to an embodiment of this application; and
FIG. 23 is another schematic flowchart of a production method for a housing structure according to an embodiment of this application.

### DESCRIPTION OF EMBODIMENTS

To make objectives, technical solutions, and advantages of this application clearer, the following further describes this application in detail with reference to the accompanying drawings.

A housing structure provided in embodiments of this application may be applied to an electronic device, for example, may be applied to any external housing of a notebook computer, a mobile phone, or a tablet computer, for example, a housing (a housing A) behind a notebook computer screen, an upper housing (a housing C) of a host, a lower housing (a housing D) of the host, or a housing of a battery rear cover. It should be noted that the housing structure provided in embodiments of this application is intended to be applied to these and any other suitable type of electronic device, but is not limited thereto. As described in the background, currently, a housing of a notebook computer cannot have advantages of both metal and non-metal. In view of this, embodiments of this application is intended to provide a housing structure with comprehensive advantages of non-metal and metal, and an appearance with an aesthetic appeal.

Terms used in the following embodiments are merely intended to describe particular embodiments, but are not intended to limit this application. As used in the specification and appended claims of the application, singular expressions "one", "a", "the", "the foregoing", "this", and "the one" are also intended to include expressions such as "one or more", unless the contrary is clearly indicated in its context.

Reference to "an embodiment", "some embodiments", or the like described in this specification means that specific features, structures, or characteristics described with reference to one or more embodiments are included in embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

FIG. 1 shows an example of a schematic diagram of a structure of a housing structure according to an embodiment of this application. Refer to FIG. 1. The housing structure includes an appearance effect layer 01, a metal layer 02, a connection layer 03, and a non-metal layer 04 that are laminated. The connection layer 03 is configured to bind the metal layer 02 and the non-metal layer 04. The appearance effect layer 01 is formed after surface processing is performed on the metal layer 02. The housing structure includes both the metal layer 02 and the non-metal layer 04. The metal layer 02 and the non-metal layer 04 are bound by using the connection layer 03, so that the housing structure has comprehensive advantages of a metal layer housing and a non-metal layer housing. In addition, the appearance effect layer 01 formed after surface processing is performed on the metal layer 02 can ensure that the housing structure has a metallic appearance with an aesthetic appeal.

In this application, the non-metal layer is mainly used to reduce overall density of the housing structure and provide strength support for the housing structure. Therefore, a material of the non-metal layer needs to have characteristics such as low density, high strength, and easy molding. Optionally, the material of the non-metal layer may include at least one of a carbon fiber composite material, a glass fiber composite material, engineering plastic, an inorganic fiber composite material, and the like. The non-metal layer is formed by using a molding process or an in-mold decoration process, and a thickness of the non-metal layer may be set to 60% to 80% of a total thickness of the housing structure. Therefore, the housing structure can have advantages of low density, high strength, an aesthetic appeal, and metallic quality, so that product competitiveness is greatly improved.

During specific implementation, the glass fiber composite material may include a glass fiber resin composite material. Further, when the glass fiber composite material includes glass fiber (GF) that accounts for 30% and polyphenylene sulfide (PPS) that accounts for 70%, an electromagnetic shielding function of the housing structure can be improved.

The engineering plastic may usually include a polycarbonate (PC), a complex of a polycarbonate (PC) and glass fiber (GF), a complex of a polycarbonate (PC) and a terpolymer (ABS), a complex of polystyrene (PG) and polyphenylene sulfide (PPS), or the like. This is not limited herein.

In this application, the appearance effect layer is formed after surface processing is performed on the metal layer, and the appearance effect layer is mainly used to improve an aesthetic appeal effect of the housing structure. During specific implementation, a surface processing manner may be anodic oxidation processing, coloring micro-arc oxidation processing, physical vapor deposition (Physical Vapor Deposition, PVD) coating processing, electrophoresis processing, nano stamping, or the like. This is not limited herein. Appearance effect layers formed in different surface processing manners further have other performance such as a protective property, an insulation property, and an improved binding force with an organic or inorganic coating. Specific performance is related to the surface processing manner, and details are not described herein. The appearance effect layer is formed after surface processing is performed on the metal layer. Therefore, a proportion of a thickness of the appearance effect layer to the total thickness of the housing structure may be ignored.

In this application, the metal layer is mainly disposed to form the appearance effect layer, and a material of the metal layer may be any metal thin-walled material that has metallic quality and on which surface processing can be performed. For example, the material of the metal layer may include at least one of a magnesium alloy, an aluminum alloy, a titanium alloy, steel, and an amorphous alloy. To make a weight of the housing structure as small as possible, a thickness of the metal layer may be set to any value provided that surface processing can be performed to form the appearance effect layer. During specific implementation, the thickness of the metal layer usually occupies 15% to 30% of the total thickness of the housing structure.

In this application, the connection layer is used to bind the metal layer and non-metal layer, and a total thickness of the connection layer usually occupies 2% to 20% of the total thickness of the housing structure.

FIG. 2 shows an example of a schematic flowchart of a production method for a housing structure according to an embodiment of this application. As shown in FIG. 2, the method mainly includes the following steps:
S201: Enable, by using a connection layer, a metal layer and a non-metal layer to be bound, to form a laminated structure with a shape of a target housing.
S202: Perform surface processing on a surface on a side that is of the metal layer and that is away from the non-metal layer, to form an appearance effect layer of the housing structure.

It should be noted that a sequence of step 5201 and step 5202 is not limited in this application. Step S202 may be performed after step S201, or step S202 may be performed before step S201. Specifically, the sequence of step 5201 and step 5202 may be determined based on a material of the non-metal layer in the housing structure and a specific surface processing manner. FIG. 2 merely shows an example in which step 5202 is performed after step S201.

To avoid damage to the appearance effect layer that is caused by the housing structure when the shape of the target housing is formed, step S202 is usually performed after step 5201. However, when the appearance effect layer is formed, if a surface processing process affects performance of the non-metal layer, step S202 needs to be performed before step S201. For example, when the surface processing process is a PVD coating process, a temperature is relatively high, and the non-metal layer is just a material, for example, a carbon fiber composite material, that is not resistant to a high temperature.

Optionally, in the housing structure of this application, the connection layer may be a glue layer. In a specific implementation process, a glue layer may be coated on a surface of the non-metal layer. Then the metal layer is press-fitted on the non-metal layer by using a holding fixture, and a temperature is increased to a curing temperature of glue, and is kept for a period of time, so that the glue is completely cured. After gluing and curing are completed, the temperature is reduced to 50 °C to 60 °C, and the holding fixture is removed to obtain the metal layer and the non-metal layer that are bound together.

A residual stress is usually generated in a molding process of a metal part, and it is difficult to eliminate the residual stress. In addition, coefficients of thermal expansion (CTE) of the metal part and a non-metal material are different in a gluing process. Therefore, a relatively large residual stress and relatively large residual deformation are generated after high-temperature curing, and a finally formed structural member is seriously deformed.

In view of this, FIG. 3 shows an example of another schematic diagram of a structure of a housing structure according to an embodiment of this application. As shown in FIG. 3, in the housing structure, a connection layer includes a first connection layer 031 and a second connection layer 032. A metal layer 02 and a non-metal layer 04 are bound by using the first connection layer 031 and the second connection layer 033. The first connection layer 031 is located on a side close to the metal layer 02, and the second connection layer 032 is located on a side close to the non-metal layer 04. In other words, in the housing structure, the metal layer and the non-metal layer are bound by using two connection layers.

Optionally, in this application, a binding force of a material of the first connection layer 03 and the metal layer 02 is greater than a binding force of a material of the second connection layer 03 and the metal layer 02, and a binding force of the material of the second connection layer 03 and the non-metal layer 04 is greater than a binding force of the material of the first connection layer 02 and the non-metal layer 04. In other words, a material with a relatively large binding force on the metal layer 02 is selected for the first connection layer 031, and a material with a relatively large binding force on the non-metal layer 04 is selected for the second connection layer 032, so that a coefficient of thermal expansion gradient between the metal layer 02 and the non-metal layer 04 is reduced, and a binding force of the metal layer 02 and the non-metal layer 04 is increased.

To prevent the binding force of the metal layer and the non-metal layer from being affected because a large quantity of bubbles are generated when the metal layer and the non-metal layer are bound by using the first connection layer and the second connection layer, the material of the first connection layer further needs to have relatively good wettability for the metal layer. Therefore, a material that can enable a contact area proportion of the first connection layer and the metal layer to be greater than or equal to 90% needs to be selected for the first connection layer. Similarly, the material of the second connection layer further needs to have relatively good wettability for the non-metal layer. Therefore, a material that can enable a contact area proportion of the second connection layer and the non-metal layer to be greater than or equal to 90% needs to be selected for the second connection layer. It should be noted that the contact area proportion is a proportion of an area of a contact region of two surfaces to an area of an overlap region of the two surfaces.

In this application, the first connection layer and the second connection layer may have a plurality of implementations. Next, for different implementations of the first connection layer and the second connection layer, the housing structure of this application is further described by using examples.

### Example 1

FIG. 4 shows an example of still another schematic diagram of a structure of a housing structure according to an embodiment of this application. Refer to FIG. 4. A first connection layer may include a first glue layer 0311, and a second connection layer may include a second glue layer 0321. Materials of the first glue layer 0311 and the second glue layer 0321 may be the same or different. The housing structure includes an appearance effect layer 01, a metal layer 02, the first glue layer 0311, the second glue layer 0321, and a non-metal layer 04 that are laminated. A material of the first glue layer 0311 may be glue with relatively strong affinity and a relatively large binding force on metal, for example, epoxy resin glue, and a material of the second glue layer 0321 may be glue with relatively strong affinity and a relatively large binding force on non-metal, for example, polyurethane glue. A material of the metal layer 02 may be any one of a magnesium alloy, an aluminum alloy, a titanium alloy, steel, and an amorphous alloy, and a material of the non-metal layer 04 may be any one of a carbon fiber composite material, a glass fiber composite material, engineering plastic, and an inorganic fiber composite material. The appearance effect layer 01 may be formed by performing any surface processing manner in anodic oxidation processing, coloring micro-arc oxidation processing, PVD coating processing, electrophoresis processing, and nano stamping processing on the metal layer 02.

FIG. 5 shows an example of a schematic flowchart of a production method for the housing structure according to the foregoing embodiment of this application. As shown in FIG. 5, the production method mainly includes the following steps.

S501: Coat a first glue layer on a side that is of a metal layer and that faces a non-metal layer, and coat a second glue layer on a side that is of the non-metal layer and that faces the metal layer.

During specific implementation, a sequence of coating the first glue layer and the second glue layer is not specifically limited. The first glue layer may be first coated on the side that is of the metal layer and that faces the non-metal layer, and then the second glue layer may be coated on the side that is of the non-metal layer and that faces the metal layer; or the second glue layer may be first coated on the side that is of the non-metal layer and that faces the metal layer, and then the first glue layer may be coated on the side that is of the metal layer and that faces the non-metal layer; or when the first glue layer is coated on the side that is of the metal layer and that faces the non-metal layer, the second glue layer may be coated on the side that is of the non-metal layer and that faces the metal layer.

S502: Perform stamping processing on the metal layer on which the first glue layer is formed and the non-metal layer on which the second glue layer is formed, to form a laminated structure with a shape of a target housing.

S503: Perform surface processing on a surface on a side that is of the metal layer and that is away from the non-metal layer, to form an appearance effect layer of the housing structure.

It should be noted that in this application, step S503 may be performed after step S502, step S503 may be performed before step S502, or step S503 may be performed before step 5501. An optimal execution time of step S503 may be specifically determined based on a material of the non-metal layer in the housing structure and a specific surface processing manner. FIG. 5 merely shows an example in which step S503 is performed after step S502.

To avoid damage to the appearance effect layer that is caused by the housing structure when the shape of the target housing is formed, step S503 is usually performed after step 5502. However, when the appearance effect layer is formed, if a surface processing process affects performance of the non-metal layer, step S503 needs to be performed before step 5502. For example, when the surface processing process is a PVD coating process, a temperature is relatively high, and the non-metal layer is just a material, for example, a carbon fiber composite material, that is not resistant to a high temperature.

Further, when step S503 is performed before step S502, to prevent a product yield from being affected because damage is caused to the appearance effect layer when the metal layer is molded, before surface processing is performed on the surface on the side that is of the metal layer and that is away from the non-metal layer, to form the appearance effect layer, the method further includes: performing stamping processing on the metal layer, so that the metal layer has an initial shape of the target housing. In other words, after the metal layer has the initial shape of the target housing, the appearance effect layer is formed on the surface of the metal layer.

An example in which the housing structure is applied to a housing A of a notebook computer and a total thickness of the housing structure needs to be 0.8 mm is used to further describe Example 1.

### Case 1

In the housing structure, a metal layer is molded by performing a stamping process on an aluminum alloy thin-walled material, for example, a 5XXX aluminum alloy thin-walled material or a 6XXX aluminum alloy thin-walled material. The metal layer has a thickness of 0.1 mm, yield strength of re, aMPa, tensile strength of re, aMPa, and elongation of A 15%. A material of a first glue layer is epoxy resin glue, a material of a second glue layer is polyurethane glue, and a total thickness of the first glue layer and the second glue layer is 0.1 mm. A non-metal layer may be molded by performing a molding process on a carbon fiber composite material. The non-metal layer has a thickness of 0.6 mm and tensile strength of A600 MPa. An appearance effect layer may be formed after anodic oxidation processing is performed on the aluminum alloy metal layer. In the molding process, the carbon fiber composite material first forms the non-metal layer with an initial shape of the housing A through molding. Then the second glue layer is coated on a surface of the non-metal layer, the first glue layer is coated on a surface of the metal layer, and the non-metal layer and the metal layer are placed in a stamping die, so that the metal layer is molded based on surface morphology of the non-metal layer, and a laminated structure with a shape of the housing A is formed after edge cutting. Finally, anodic oxidation processing is performed on the surface of the metal layer to finally obtain the housing structure with the shape of the housing A. A process route corresponding to the housing structure is shown in FIG. 6. As shown in FIG. 7, a specific production method for the housing structure includes the following steps.

S701: Form a non-metal layer with an initial shape of a housing A by using a molding process.

During specific implementation, filament fiber in carbon fiber of T600, T800, or higher is woven in a length direction of the housing A, and is combined with a resin material, and the non-metal layer that is of a carbon fiber polymer matrix composite material and that has the initial shape of the housing A is molded by using the molding process. A used molding die is designed in advance based on a shape of the housing A, and a height between a male die face and a female die face of the molding die is 0.6 mm, so that a film layer of 0.6 mm can be formed. Molding pressure is controlled at approximately 0.5 MPa, a molding temperature is controlled at 50°C to 200°C, and holding time is controlled at 15 min to 60 min.

S702: Coat a second glue layer on a side that is of the non-metal layer and that faces a metal layer.

During specific implementation, a polyurethane glue layer is coated, through glue brushing, on the side that is of the non-metal layer with the initial shape of the housing A and that faces the metal layer, and a thickness of the polyurethane glue layer is 0.045 mm to 0.055 mm. A glue brushing width and a structural form of a glue brushing fixture are designed based on a shape of the non-metal layer, to ensure that coating is completed after a maximum of two times of glue brushing. A glue brushing speed is 10 mm/s to 15 mm/s, so that it can be ensured that the thickness of the polyurethane glue layer is uniform.

S703: Form a metal layer of a specified size.

During specific implementation, a thin aluminum alloy plate of a thickness 0.1 mm is cut to a corresponding size through laser cutting based on a product requirement, to obtain a metal layer of the thickness 0.1 mm that has a size corresponding to the shape of the housing A. Laser power is 20 W to 30 W, a speed is 100 mm/s to 200 mm/s, and the thin aluminum alloy plate may be a thin 5052-H32 aluminum alloy plate.

S704: Coat a first glue layer on a side that is of the metal layer and that faces the non-metal layer.

During specific implementation, the metal layer may be placed in a corresponding fixture for fastening, and an epoxy resin glue layer is coated, through glue brushing, on the side that is of the metal layer and that faces the non-metal layer. A thickness of the epoxy resin glue layer is 0.045 mm to 0.055 mm. A glue brushing width is consistent with a width of the housing A, glue brushing is completed at a time, and a glue brushing speed is 10 mm/s to 15 mm/s, to ensure that the thickness of the epoxy resin glue layer is uniform.

S705: Perform stamping processing on the metal layer on which the first glue layer is coated and the non-metal layer on which the second glue layer is coated, to form a laminated structure with a shape of the housing A.

During specific implementation, the non-metal layer on which the second glue layer is coated is placed in a female die of a stamping die and fastened. In addition, the metal layer on which the first glue layer is coated is placed in a male die. The first glue layer is opposite to the second glue layer. The stamping die is pressed, so that the metal layer is molded into a surface shape of the non-metal layer, and after a period of time, the stamping die is released and edge cutting is performed to obtain the molded laminated structure with the shape of the housing A. Holding pressure is 30 T to 50 T, and holding time is 10 min to 30 min.

S706: Perform anodic oxidation processing on a surface on a side that is of the metal layer and that is away from the non-metal layer, to form an appearance effect layer of the housing structure.

During specific implementation, before anodic oxidation processing is performed on the surface on the side that is of the metal layer and that is away from the non-metal layer, processing such as acid and alkali washing, pure water cleaning, and polishing needs to be performed on the molded laminated structure with the shape of the housing A. After anodic oxidation processing is performed on the surface on the side that is of the metal layer and that is away from the non-metal layer, processes such as ultrasonic cleaning and drying further need to be performed, to finally obtain the housing structure that can be applied to the housing A of the notebook computer. The housing structure has an appearance effect obtained through anodic oxidation, and has tensile strength of 600 MPa or higher and density of 1.70 g/cm3 to 1.80 g/cm3, so that requirements on a weight, a metallic appearance, appearance reliability, mechanical strength, and the like of an applied product can be met. Further, if the product has a requirement on a color of the appearance effect layer, coloring processing may be performed after the anodic oxidation processing.

In the foregoing housing structure provided in this application, while a metallic appearance obtained after anodic oxidation is performed on an aluminum alloy is achieved, the density of the housing can be reduced to 1.70 g/cm3 to 1.80 g/cm3, and tensile strength can be increased to 600 MPa or higher. Compared with the aluminum alloy, the density is reduced by at least 34%, and the strength is increased by at least 120%, so that requirements on a weight, a metallic appearance, appearance reliability, mechanical strength, and the like of an applied product can be met.

### Case 2

Differences from Case 1 are as follows: In the housing structure, a metal layer is formed by performing a stamping process on a steel thin-walled material, for example, a stainless steel thin-walled material. The stainless steel may be specifically 304, 316, or 316L stainless steel. The metal layer has a thickness of 0.1 mm, yield strength of ≥250 MPa, tensile strength of 1 areMPa, and elongation of ≥30%. An appearance effect layer is formed by performing PVD coating processing on the steel metal layer. In a molding process, a carbon fiber composite material first forms a non-metal layer with an initial shape of the housing A through molding. Then a second glue layer is coated on a surface of the non-metal layer, a thin steel plate is stamped into the metal layer with the initial shape of the housing A, a first glue layer is coated on a surface of the metal layer, the non-metal layer and the metal layer are placed in a stamping die and press-fitted, and a combined structure with a shape of the housing A is molded after edge cutting. A process route corresponding to the housing structure is shown in FIG. 8. As shown in FIG. 9, a specific production method for the housing structure includes the following steps.

S901: Form a non-metal layer with an initial shape of a housing A by using a molding process.

During specific implementation, filament fiber in carbon fiber of T600, T800, or higher is woven in a length direction of the housing A, and is combined with a resin material, and the non-metal layer that is of a carbon fiber polymer matrix composite material and that has the initial shape of the housing A is molded by using the molding process. A used molding die is designed based on a shape of the housing A, and a height between a male die face and a female die face of the molding die is 0.6 mm, so that a film layer of 0.6 mm can be formed. Molding pressure is controlled at approximately 0.5 MPa, a molding temperature is controlled at 50°C to 200°C, and holding time is controlled at 15 min to 60 min.

S902: Coat a second glue layer on a side that is of the non-metal layer and that faces a metal layer.

During specific implementation, a polyurethane glue layer is coated, through glue brushing, on a side that is of the non-metal layer with the initial shape of the housing A and that faces the metal layer, and a thickness of the polyurethane glue layer is 0.045 mm to 0.055 mm. A glue brushing width and a structural form of a glue brushing fixture are designed based on a shape of the non-metal layer, to ensure that coating is completed after a maximum of two times of glue brushing. A glue brushing speed is 10 mm/s to 15 mm/s, so that it can be ensured that the thickness of the polyurethane glue layer is uniform.

S903: Form a metal layer of a specified size.

During specific implementation, a thin stainless steel plate of a thickness 0.1 mm is cut to a corresponding size through laser cutting based on a product requirement, to obtain a metal layer of the thickness 0.1 mm that has a size corresponding to the shape of the housing A. Laser power is 20 W to 30 W, a speed is 100 mm/s to 200 mm/s, and the thin stainless steel plate may be a thin SUS316 stainless steel plate.

S904: Form a metal layer with the initial shape of the housing A.

During specific implementation, the metal layer of the specified size and the thickness 0.1 mm is placed in a corresponding stamping die for stamping molding, so that the metal layer has the initial shape of the housing A. Stamping pressure is at least 20 T to 30 T, holding time is at least 3 min, and a stamping temperature is a room temperature.

S905: Perform PVD coating processing on a side that is of the metal layer and that is away from the non-metal layer, to form an appearance effect layer.

During specific implementation, the side that is of the metal layer and that is away from the non-metal layer is cleaned, and then PVD coating processing is performed on the side. An appropriate sputtering target may be selected for PVD coating processing based on a product color requirement. A furnace temperature is kept at 80 °C to 120 °C.

S906: Coat a first glue layer on a side that is of the metal layer and that faces the non-metal layer.

During specific implementation, the metal layer may be placed in a corresponding fixture for fastening, and an epoxy resin glue layer is coated, through glue brushing, on the side that is of the metal layer and that faces the non-metal layer. A thickness of the epoxy resin glue layer is 0.045 mm to 0.055 mm. A glue brushing width is consistent with a width of the housing A, glue brushing is completed at a time, and a glue brushing speed is 10 mm/s to 15 mm/s, to ensure that the thickness of the epoxy resin glue layer is uniform.

S907: Perform stamping processing on the metal layer on which the first glue layer is coated and the non-metal layer on which the second glue layer is coated, to form the housing structure with the shape of the housing A.

During specific implementation, the non-metal layer on which the second glue layer is coated is placed in a female die of a stamping die and fastened. In addition, the metal layer on which the first glue layer is coated is placed in a male die. The first glue layer is opposite to the second glue layer. The stamping die is pressed, so that the metal layer and the non-metal layer are bound, and after a period of time, the stamping die is released and edge cutting is performed to obtain the molded housing structure with the shape of the housing A. Holding pressure is 30 T to 50 T, and holding time is 10 min to 30 min.

Further, processes such as acid and alkali washing, pure water cleaning, polishing, ultrasonic cleaning, and drying need to be performed on the molded housing structure with the shape of the housing A, to finally obtain the housing structure that can be applied to the housing A of the notebook computer. The housing structure has an appearance obtained through PVD coating, and has tensile strength of 700 MPa or higher and density of 2.40 g/cm3 to 2.50 g/cm3, so that requirements on a weight, a metallic appearance, appearance reliability, mechanical strength, and the like of an applied product can be met.

In the foregoing housing structure provided in this application, while a metallic appearance obtained after PVD coating is performed on stainless steel is achieved, the density of the housing material can be reduced to 2.40 g/cm3 to 2.50 g/cm3, and tensile strength can be increased to 700 MPa or higher. Compared with the stainless steel, the density is reduced by at least 65%, so that requirements on a weight, a metallic appearance, appearance reliability, mechanical strength, and the like of an applied product can be met.

In Example 1, the housing structure has comprehensive advantages of non-metal and metal. There are two connection layers. The first connection layer and the second connection layer respectively have relatively strong affinity and relatively large binding forces for the metal and the non-metal. In comparison with the conventional technology, a binding force of the metal layer and the non-metal layer is greatly increased, and a coefficient of thermal expansion (CTE) gradient is reduced, so that a housing structure with a complex structural form can be molded, and a deformation degree of the housing structure can be well controlled. The non-metal layer is molded into the initial shape of the target housing by using the molding process. The metal layer and the non-metal layer are combined through gluing, stamping molding is performed by using good elongation of the metal layer and the glue layer, and further, the metal layer and the glue layer are bound to a surface of the non-metal layer, so that the housing structure can be mass-producible and commercially available to applied products in terms of processes.

### Example 2

FIG. 10 shows an example of still another schematic diagram of a structure of a housing structure according to an embodiment of this application. Refer to FIG. 10. A first connection layer may include a solder layer 0312, and a second connection layer may include an electroplated coating 0322. The housing structure includes an appearance effect layer 01, a metal layer 02, the solder layer 0312, the electroplated coating 0322, and a non-metal layer 04 that are laminated. A material of the solder layer 0312 may be a low-temperature solder such as a tin-based solder. Further, for environmental protection, the material of the solder layer 0312 may be a lead-free tin-based solder. The electroplated coating 0322 is formed by electroplating metal on the non-metal layer 04, and a material of the electroplated coating 0322 may be any one of tin, chromium, nickel, silver, and copper. When the material of the solder layer 0312 is a tin-based solder, to increase a binding force, the material of the electroplated coating 0322 may be tin. A material of the metal layer 02 may be any one of a magnesium alloy, an aluminum alloy, a titanium alloy, steel, and an amorphous alloy, and a material of the non-metal layer 04 may be any one of a carbon fiber composite material, a glass fiber composite material, engineering plastic, and an inorganic fiber composite material. The appearance effect layer 01 may be formed by performing any surface processing manner in anodic oxidation processing, coloring micro-arc oxidation processing, PVD coating processing, electrophoresis processing, and nano stamping processing on the metal layer 02.

FIG. 11 shows an example of a schematic flowchart of a production method for the housing structure according to the foregoing embodiment of this application. As shown in FIG. 11, the method mainly includes the following steps.

S1101: Form, by using an electroplating process, an electroplated coating on a side that is of a non-metal layer and that faces a metal layer.

S1102: Form a solder layer between the metal layer and the electroplated coating, and perform soldering processing, so that the metal layer and the non-metal layer are bound by using the solder layer and the electroplated coating.

During specific implementation, a sheet-like solder layer is sandwiched between the metal layer and the electroplated coating; or a paste solder layer is coated on a surface of the electroplated coating or a side that is of the metal layer and that faces the non-metal layer; and then the three are completely press-fitted together by using a fixture to perform soldering processing.

S1103: Perform stamping processing on the metal layer and the non-metal layer that are bound, to form a laminated structure with a shape of a target housing.

S 1104: Perform surface processing on a surface on a side that is of the metal layer and that is away from the non-metal layer, to form an appearance effect layer of the housing structure.

An example in which the housing structure is applied to a housing D of a notebook computer and a total thickness of the housing structure needs to be 0.7 mm is used.

In the housing structure, the metal layer is made of a stainless steel thin-walled material or a titanium alloy thin-walled material, for example, 304, 316, or 316L stainless steel thin-walled material or a TC4 titanium alloy thin-walled material. The metal layer has a thickness of 0.1 mm, yield strength of ≥250 MPa, tensile strength of ≥ 600 MPa, and elongation of ≥30%. The non-metal layer is made of a glass fiber composite material, for example, a glass fiber resin composite material. The non-metal layer has a thickness of 0.5 mm and tensile strength of ≥500 MPa. The electroplated coating is formed by electroplating metal, for example, plating tin or chromium, on the non-metal layer. A thickness of the electroplated coating is 15 µm, and there is a conventional cross-cut adhesion force of V4B between the electroplated coating and the non-metal layer. The solder layer includes a tin-based solder layer. For example, a tin-based paste solder is uniformly coated on the side that is of the non-metal layer and that faces the metal layer. Alternatively, the tin-based paste solder is coated on the electroplated coating. Alternatively, a tin-based sheet-like solder is sandwiched between the metal layer and the electroplated coating. A thickness of the solder layer is 85 µm. The appearance effect layer may be formed by performing PVD coating processing on the metal layer, and may be in various colors such as gray, silver, green, and pink. In a molding process, the glass fiber composite material is first molded into a plate through in-mold decoration, an electroplated coating is electroplated on a surface of the plate, and then the solder layer is formed between the electroplated coating and the metal layer. Then soldering processing is performed to solder the metal layer and the non-metal layer into an entire thin plate. Finally, a laminated structure with a shape of the housing D is formed by using a stamping process, and finally, PVD coating processing is performed on a surface of the metal layer to finally obtain the housing structure with the shape of the housing D. A process route corresponding to the housing structure is shown in FIG. 12. As shown in FIG. 13, a specific production method for the housing structure includes the following steps.

S1301: Form a non-metal layer by using an in-mold decoration process.

During specific implementation, a glass fiber resin composite material is heated to an injection molding temperature, and is molded into a non-metal layer of a glass fiber resin composite material of a thickness 0.5 mm in an injection molding die by using the in-mold decoration process, and then the non-metal layer is cleaned. An in-mold decoration temperature is 120 °C to 250°C, injection molding pressure is 20 T to 50 T, and injection molding time is 10 min to 30 min. A size of the injection molding die is designed based on a size of a housing D.

S1302: Form, by using an electroplating process, an electroplated coating on a side that is of the non-metal layer and that faces a metal layer.

During specific implementation, the electroplated coating is electroplated on the cleaned non-metal layer, and a material of the electroplated coating may be chromium or tin. Because a tin-based solder is used for a solder layer, when the material of the electroplated coating is tin, a binding force of the metal layer and the non-metal layer can be increased.

S1303: Form a metal layer of a specified size.

During specific implementation, a thin stainless steel plate or a thin titanium alloy plate of a thickness 0.1 mm is cut to a corresponding size through laser cutting based on a product requirement, to obtain a metal layer of 0.1 mm that has a size corresponding to a shape of the housing D. Laser power is 20 W to 30 W, and a speed is 100 mm/s to 200 mm/s. The thin stainless steel plate may be a thin SUS316 stainless steel plate, and the thin titanium alloy plate may be a thin TC4 titanium alloy plate.

S 1304: Form a solder layer between the metal layer and the electroplated coating, and perform soldering processing, so that the metal layer and the non-metal layer are bound by using the solder layer and the electroplated coating.

During specific implementation, a sheet-like solder layer of a thickness 0.085 mm is sandwiched between the metal layer and the electroplated coating; or a paste solder layer of the thickness 0.085 mm is coated on a surface of the electroplated coating or a side that is of the metal layer and that faces the non-metal layer; and then the three are completely press-fitted together by using a fixture and sent to a continuous tunnel furnace with an inert atmosphere for soldering processing. A soldering temperature is 180°C to 300°C, soldering time is 20 min to 45 min, and holding pressure is 20 N to 40 N. A material of the solder layer may be an environmentally friendly lead-free tin-based solder such as a sheet-like solder of Sn80Bi20.

S1305: Perform stamping processing on the metal layer, the solder layer, the electroplated coating, and the non-metal layer that are bound, to form a laminated structure with the shape of the housing D.

During specific implementation, the non-metal layer and the metal layer that are well soldered are placed, for stamping processing, in a stamping die designed based on a product structure, and are molded, and precision machining is performed to remove an extra edge to form the laminated structure with the shape of the housing D. Stamping pressure is at least 50 T, holding time is at least 3 min, and a stamping temperature is a room temperature.

Further, acid and alkali washing, pure water cleaning, polishing, ultrasonic cleaning, and drying further need to be performed on the laminated structure with the shape of the housing D, so that the laminated structure has a clean surface.

S1306: Perform PVD coating processing on a surface on a side that is of the metal layer and that is away from the non-metal layer, to form an appearance effect layer of the housing structure.

During specific implementation, an appropriate coating may be selected based on a product requirement, and a thickness of the coating is controlled within a range of 15 µm to 25 µm, to obtain a housing structural member that finally has an appearance of a PVD decorative coating.

In the foregoing housing structure provided in this application, while a metallic appearance obtained after PVD coating is performed on stainless steel or a titanium alloy is achieved, tensile strength is increased to 600 MPa or higher. Compared with the stainless steel, density can be reduced by at least 60%, so that requirements on a weight, a metallic appearance, appearance reliability, mechanical strength, and the like of an applied product can be met.

In Example 2, the housing structure has comprehensive advantages of non-metal and metal. The solder layer and the electroplated coating are used as intermediate connection layers between the metal layer and the non-metal layer, and the metal layer and the non-metal layer are bound through soldering. A CTE gradient of the housing structure is greatly reduced, so that a housing structure with a complex structural form can be molded, and a deformation degree of the housing structure can be well controlled. In comparison with Example 1, a binding force of the metal layer and the non-metal layer can be relatively stable by using a soldering technology, and long-term stability is greatly improved, so that stamping molding processing in a subsequent process can be met, to be specific, a raw material manufacturer and a processing manufacturer can be independent of each other, and intermediate storage time efficiency is greatly improved.

### Example 3

FIG. 14 shows an example of still another schematic diagram of a structure of a housing structure according to an embodiment of this application. Refer to FIG. 14. A first connection layer may include a micro-nano porous layer 0313, and a second connection layer may include a glue layer 0323. The housing structure includes an appearance effect layer 01, a metal layer 02, the micro-nano porous layer 0313, the glue layer 0323, and a non-metal layer 04 that are laminated. A material of the glue layer 0323 may be formed by mixing two types of resin glue based on a specific proportion, for example, AB resin glue. The micro-nano porous layer 0313 is formed after micro-nano pore etching processing is performed on the metal layer 02, so that a binding force of the glue layer 0323 and the metal layer 02 can be increased. A material of the metal layer 02 may be any one of a magnesium alloy, an aluminum alloy, a titanium alloy, steel, and an amorphous alloy, and a material of the non-metal layer 04 may be any one of a carbon fiber composite material, a glass fiber composite material, engineering plastic, and an inorganic fiber composite material. The appearance effect layer 01 may be formed by performing any surface processing manner in anodic oxidation processing, coloring micro-arc oxidation processing, PVD coating processing, electrophoresis processing, and nano stamping processing on the metal layer 02.

FIG. 15 shows an example of a schematic flowchart of a production method for the housing structure according to the foregoing embodiment of this application. As shown in FIG. 15, the method mainly includes the following steps.

S1501: Perform micro-nano pore etching processing on a side that is of a metal layer and that faces a non-metal layer, to form a micro-nano porous layer, and attach a glue layer on the side that is of the metal layer and that faces the non-metal layer.

During implementation, a sequence of forming the micro-nano porous layer and attaching the glue layer is not specifically limited. Micro-nano pore etching processing may be first performed on the side that is of the metal layer and that faces the non-metal layer, to form the micro-nano porous layer, and then the glue layer may be attached on the side that is of the metal layer and that faces the non-metal layer; or the glue layer may be first attached on the side that is of the metal layer and that faces the non-metal layer, and then micro-nano pore etching processing may be performed on the side that is of the metal layer and that faces the non-metal layer; or when micro-nano pore etching processing is performed on the side that is of the metal layer and that faces the non-metal layer, to form the micro-nano porous layer, the glue layer may be attached on the side that is of the metal layer and that faces the non-metal layer.

S1502: Perform stamping processing on the metal layer on which the micro-nano porous layer is formed and the non-metal layer on which the glue layer is attached, to form a laminated structure with a shape of a target housing.

S 1503: Perform surface processing on a surface on a side that is of the metal layer and that is away from the non-metal layer, to form an appearance effect layer of the housing structure.

An example in which the housing structure is applied to a housing A of a notebook computer and a total thickness of the housing structure needs to be 0.8 mm is used.

In the housing structure, the metal layer is made of a titanium alloy thin-walled material, for example, a TA7 or TC4 titanium alloy thin-walled material. The metal layer has a thickness of 0.1 mm, yield strength of ≥280 MPa, tensile strength of re, tMPa, and elongation of ≥30%. The non-metal layer is made of engineering plastic, for example, PC and ABS. The non-metal layer has a thickness of 0.55 mm and tensile strength of titaMPa. A material of the glue layer is AB resin glue, and a thickness of the glue layer is 0.1 mm. The micro-nano porous layer is formed after micro-nano pore etching processing is performed on the metal layer, and the appearance effect layer may be formed by performing nano stamping processing on the metal layer. In a molding process, the engineering plastic is first molded into a non-metal layer with an initial shape of the housing A through injection molding, the glue layer of the thickness 0.1 mm is attached to a surface of the non-metal layer, and then the metal layer on which the micro-nano porous layer is formed and the metal layer on which the glue layer is attached are press-fitted through stamping molding, so that a shape of the housing A is formed. Then nano stamping processing is performed on a surface of the metal layer to finally obtain the housing structure with the shape of the housing D. A process route corresponding to the housing structure is shown in FIG. 16. As shown in FIG. 17, a specific production method for the housing structure includes the following steps.

S1701: Form a non-metal layer with an initial shape of a housing A by using a molding process.

During specific implementation, a non-metal layer of engineering plastic with a shape of the housing A is formed by using the molding process. A used molding die is designed based on a shape of the housing A, and a height between a male die face and a female die face of the molding die is 0.55 mm, so that a film layer of 0.55 mm can be formed. Molding pressure is controlled at 0.5 MPa to 1.0 MPa, a molding temperature is controlled at 150°C to 300°C, and holding time is controlled at 25 min to 60 min.

S1702: Attach a glue layer on a side that is of the non-metal layer and that faces a metal layer.

During specific implementation, a material of the glue layer is AB resin glue, and a thickness of the glue layer is 0.1 mm.

S1703: Form a metal layer of a specified size.

During specific implementation, a thin TC4 titanium alloy plate of a thickness 0.15 mm is cut to a corresponding size through laser cutting based on a product requirement, to obtain a metal layer of the thickness 0.15 mm that has a size corresponding to the shape of the housing A. Laser power is 20 W to 30 W, and a speed is 100 mm/s to 200 mm/s.

S1704: Perform micro-nano pore etching processing on a side that is of the metal layer and that faces the non-metal layer, to form a micro-nano porous layer.

During specific implementation, the metal layer is placed in a corresponding fixture for fastening, and the micro-nano porous layer is formed on a surface of the metal layer by using a nano pore etching process, to increase an adhesion force of the glue layer.

A chemical treatment method may be used in the nano pore etching process. To speed up processing, an electrochemical treatment method may be alternatively used, but costs also increase accordingly. When the chemical treatment method is used, 25% ammonia water (NH40H), 30% hydrogen peroxide (H2O2), and deionized water (DI water) may be used at a molar ratio of 1:1:5 to configure a corrosive liquid. Then the corrosive liquid is heated to 70 °C, and the temperature is kept for 1 min to 2 min. The metal layer is placed in the corrosive liquid, and is corroded for 25 min to 30 min to form a TiO2 micro-nano pore structure on a surface of the metal layer.

S1705: Perform stamping processing on the non-metal layer on which the glue layer is attached and the metal layer on which the micro-nano porous layer is formed, to form a laminated structure with the shape of the housing A.

The non-metal layer on which the glue layer is attached is placed in a female die of a stamping die and fastened. In addition, the metal layer on which the micro-nano porous layer is formed is placed in a male die. The stamping die is pressed, so that the metal layer is molded into a surface shape of the non-metal layer, and after a period of time, the stamping die is released and edge cutting is performed to obtain the molded laminated structure with the shape of the housing A. Holding pressure is 30 T to 50 T, and holding time is 10 min to 30 min.

S1706: Perform nano stamping processing on a surface on a side that is of the metal layer and that is away from the non-metal layer, to form an appearance effect layer of the housing structure.

During specific implementation, nano stamping patterns may present various appearance effects such as a concentric circle, a CD pattern, and an anodized appearance effect. Before nano stamping processing is performed on the surface on the side that is of the metal layer and that is away from the non-metal layer, processing such as acid and alkali washing, pure water cleaning, and polishing needs to be performed on the molded laminated structure with the shape of the housing A. After nano stamping processing is performed on the surface on the side that is of the metal layer and that is away from the non-metal layer, processes such as ultrasonic cleaning and drying further need to be performed, to finally obtain the housing structure that can be applied to the housing A of the notebook computer. The housing structure has an appearance obtained through anodic oxidation, and has tensile strength of 600 MPa or higher and density of 2.20 g/cm3 to 2.50 g/cm3, so that requirements on a weight, a metallic appearance, appearance reliability, mechanical strength, and the like of an applied product can be met.

During specific implementation, if the product has a requirement on a color of the appearance effect layer, coloring processing may be performed after the nano stamping processing.

In the foregoing housing structure provided in this application, while an appearance effect obtained after nano stamping is performed on a titanium alloy is implemented, density of the housing structure can be reduced to 2.20 g/cm3 to 2.50 g/cm3, and tensile strength can be increased to 600 MPa or higher. Compared with the titanium alloy, the density is reduced by at least 45%, so that requirements on a weight, a metallic appearance, appearance reliability, mechanical strength, and the like of an applied product can be met.

In Example 3, the housing structure has comprehensive advantages of non-metal and metal. The metal layer and the non-metal layer are bound by using the micro-nano porous layer and the glue layer. In comparison with a conventional gluing process, the micro-nano porous layer can greatly increase a binding force of the metal and the non-metal. The engineering plastic is molded into a product with the shape of the housing, and there is only one glue layer, so that the housing structure can be mass-producible and commercially available to applied products in terms of processes.

### Example 4

FIG. 18 shows an example of still another schematic diagram of a structure of a housing structure according to an embodiment of this application. Refer to FIG. 18. A first connection layer may include a micro-nano porous layer 0314, and a second connection layer may include a surface pore filling layer 0324. The housing structure includes an appearance effect layer 01, a metal layer 02, the micro-nano porous layer 0314, the surface pore filling layer 0324, and a non-metal layer 04 that are laminated. A material of the surface pore filling layer 0324 is the same as a material of the non-metal layer 04, and may be formed by using an injection molding process or a heat-processing inlaying process. The micro-nano porous layer 0313 is formed after micro-nano pore etching processing is performed on the metal layer 02, so that a binding force of a glue layer 0323 and the metal layer 02 can be increased. A material of the metal layer 02 may be any one of a magnesium alloy, an aluminum alloy, a titanium alloy, steel, and an amorphous alloy, and a material of the non-metal layer 04 may be any one of a carbon fiber composite material, a glass fiber composite material, engineering plastic, and an inorganic fiber composite material. The appearance effect layer 01 may be formed by performing any surface processing manner in anodic oxidation processing, coloring micro-arc oxidation processing, PVD coating processing, electrophoresis processing, and nano stamping processing on the metal layer 02.

FIG. 19 shows an example of a schematic flowchart of a production method for the housing structure according to the foregoing embodiment of this application. As shown in FIG. 19, the method mainly includes the following steps.

S1901: Form a metal layer with an initial shape of a target housing.

S1902: Perform micro-nano pore etching processing on a side that is of the metal layer and that faces a non-metal layer, to form a micro-nano porous layer.

S1903: Form a surface pore filling layer, and form the non-metal layer on a side that is of the surface pore filling layer and that is away from the metal layer, to obtain a laminated structure with a shape of the target housing.

During specific implementation, a non-metal material may be injected into the micro-nano porous layer by using an injection molding process, to form the surface pore filling layer, and the non-metal layer may be formed on the side that is of the surface pore filling layer and that is away from the metal layer, to obtain the laminated structure with the shape of the target housing; or a non-metal material may be inlaid into the micro-nano porous layer by using a heat-processing inlaying process, to form the surface pore filling layer, and the non-metal layer may be formed on the side that is of the surface pore filling layer and that is away from the metal layer, to obtain the laminated structure with the shape of the target housing.

S 1904: Perform surface processing on a surface on a side that is of the metal layer and that is away from the non-metal layer, to form an appearance effect layer of the housing structure.

An example in which the housing structure is applied to a housing C of a notebook computer and a total thickness of the housing structure needs to be 0.8 mm is used.

In the housing structure, the metal layer is made of an aluminum alloy thin-walled material, for example, a 5XXX aluminum alloy thin-walled material or a 6XXX aluminum alloy thin-walled material. The metal layer has a thickness of 0.15 mm, yield strength of ≥ 150 MPa, tensile strength of re, tMPa, and elongation of ≥ 15%. The non-metal layer is made of a glass fiber composite material. For example, the glass fiber composite material includes glass fiber (GF) that accounts for 30% and polyphenylene sulfide (PPS) that accounts for 70%. The non-metal layer has a thickness of 0.55 mm and tensile strength of examMPa. The micro-nano porous layer is formed after micro-nano pore etching processing is performed on the metal layer. The appearance effect layer may be formed by performing anodic oxidation processing on the metal layer. A material of the surface pore filling layer is the same as a material of the non-metal layer, and may be formed by inlaying non-metal into the micro-nano porous layer by using the injection molding process or the heat-processing inlaying process. In a molding process, stamping processing is performed on the metal layer of the thickness 0.15 mm, so that the metal layer has an initial shape of the housing C, and the micro-nano porous layer is formed on a surface of the metal layer by using a micro-nano pore etching process. Then a non-metal material is inlaid into the micro-nano porous layer by using the injection molding process or the heat-processing inlaying process, to form the surface pore filling layer and also form the non-metal layer. Finally, anodic oxidation processing is performed on the side that is of the metal layer and that is away from the non-metal layer, to obtain the housing structure with a shape of the housing C. A process route corresponding to the housing structure is shown in FIG. 20. As shown in FIG. 21, a specific production method for the housing structure includes the following steps.

S2101: Form a metal layer with an initial shape of a housing C.

During specific implementation, a thin aluminum alloy plate of a thickness 0.15 mm is cut to a corresponding size through laser cutting, and is placed in a stamping die for stamping processing to form the initial shape of the housing C. A molding die is designed based on a product structure. A height between a male die face and a female die face of the molding die is 0.15 mm, molding pressure is approximately 0.5 MPa, and holding time is 5 min to 10 min. The thin aluminum alloy plate may be a thin 6063-T6 aluminum alloy plate.

S2102: Perform micro-nano pore etching processing on a side that is of the metal layer and that faces a non-metal layer, to form a micro-nano porous layer.

During specific implementation, the metal layer is cleaned, grease impurities are removed, small-sized honeycomb-like nano pores are obtained by etching a surface of the metal layer by using a nano pore etching process, and finally, a nano-level coral reef structure is formed on the surface of the metal layer, in other words, the micro-nano porous layer is formed. A chemical treatment method may be used in the nano pore etching process. To speed up processing, an electrochemical treatment method may be alternatively used, but costs also increase accordingly. When the chemical treatment method is used, processing time is 3 min to 10 min.

S2103: Inlay a non-metal material into the micro-nano porous layer by using an injection molding process or a heat-processing inlaying process, to form a surface pore filling layer, and also form the non-metal layer, to obtain a laminated structure with a shape of the target housing.

During specific implementation, the metal layer obtained after the nano pore etching processing is cleaned, dried, and placed in a nano injection molding die, PPS and GF that accounts for 30% are injected to form the surface pore filling layer, and the non-metal layer is also formed. Injection molding pressure is approximately 0.5 MPa to 1.0 MPa, a molding temperature is approximately 150 °C to 300 °C, and holding time is 15 min to 40 min. Alternatively, the metal layer obtained after the nano pore etching processing is cleaned and dried, and a surface of the non-metal layer is inlaid into the micro-nano porous layer by using the heat-processing inlaying process, to form the surface pore filling layer. Therefore, the non-metal layer is reliably connected to the metal layer by using the micro-nano porous layer.

S2104: Perform anodic oxidation processing on a surface on a side that is of the metal layer and that is away from the non-metal layer, to form an appearance effect layer of the housing structure.

During specific implementation, before anodic oxidation processing is performed on the surface on the side that is of the metal layer and that is away from the non-metal layer, processing such as acid and alkali washing, pure water cleaning, and polishing needs to be performed on the molded laminated structure with a shape of the housing C. After anodic oxidation processing is performed on the surface on the side that is of the metal layer and that is away from the non-metal layer, processes such as ultrasonic cleaning and drying further need to be performed, to finally obtain the housing structure that can be applied to the housing C of the notebook computer. The housing structure has an appearance effect obtained through anodic oxidation, and has tensile strength of 600 MPa or higher and density of 1.70 g/cm3 to 1.80 g/cm3, in other words, the density is reduced by at least 34%, and the strength is improved by at least 120%, so that requirements on a weight, a metallic appearance, appearance reliability, mechanical strength, and the like of an applied product can be met.

In Example 4, the housing structure has comprehensive advantages of non-metal and metal. The non-metal layer and the metal layer are directly combined together by using the micro-nano porous layer and the injection molding process or the heat-processing inlaying process, to reduce intermediate processes and achieve a better economic effect, so that the housing structure can be mass-producible and commercially available to applied products in terms of processes.

### Example 5

FIG. 22 shows an example of still another schematic diagram of a structure of a housing structure according to an embodiment of this application. Refer to FIG. 22. A connection layer further includes a third connection layer, a first connection layer may include a micro-nano porous layer 0314, and a second connection layer may include a surface pore filling layer 0324. The third connection layer may include a glue layer 033. The housing structure includes an appearance effect layer 01, a metal layer 02, the micro-nano porous layer 0314, the surface pore filling layer 0324, the glue layer 033, and a non-metal layer 04 that are laminated. Differences from Example 4 are as follows: In Example 4, the non-metal layer is formed while the surface pore filling layer is formed. In Example 5, a non-metal material is injected or inlaid into the micro-nano porous layer by using an injection molding process or a heat-processing inlaying process, to form the surface pore filling layer, and then the surface pore filling layer and the non-metal layer are bound by using the glue layer.

FIG. 23 shows an example of a schematic flowchart of a production method for the housing structure according to the foregoing embodiment of this application. As shown in FIG. 23, the method mainly includes the following steps:
S2301: Form a metal layer with an initial shape of a target housing.

S2302: Perform micro-nano pore etching processing on a side that is of the metal layer and that faces a non-metal layer, to form a micro-nano porous layer.

S2303: Inlay a non-metal material into the micro-nano porous layer by using an injection molding process or a heat-processing inlaying process, to form a surface pore filling layer.

S2304: Enable, by using a glue layer, the surface pore filling layer and the non-metal layer to be bound, to obtain a laminated structure with a shape of the target housing.

S2305: Perform surface processing on a surface on a side that is of the metal layer and that is away from the non-metal layer, to form an appearance effect layer of the housing structure.

In conclusion, in this application, for a non-metal material that is a thermoplastic material, for example, a carbon fiber composite material, the non-metal layer may be molded into a housing shape, and only stamping molding needs to be subsequently used for the metal layer. Therefore, a material, for example, a 5052-T6 aluminum alloy, that has relatively good elongation and on which stamping molding can be performed needs to be used for the metal layer. The molded non-metal layer and metal layer are placed in a stamping die, and then stamping molding is performed on the metal layer. For a non-metal material that is a thermosetting material, for example, a glass fiber composite material, a sheet material may be formed through in-mold decoration, and finally the sheet material is molded into a housing shape through stamping molding.

It should be noted that, in this application, a thickness ratio of the metal layer, the connection layer, and the non-metal layer may be adjusted to implement optimization between density and strength.

The housing structure provided in embodiments of this application may be applied to an electronic device. The electronic device provided in this application includes a housing structure in any one of the foregoing technical solutions of this application and a circuit board. The housing structure is located on an outer side of the circuit board. A problem resolving principle of the electronic device is similar to that of the foregoing housing structure. Therefore, for implementation of the electronic device, refer to implementation of the foregoing housing structure. Details are not described again. The housing structure provided in this application has advantages of a metal layer housing and a non-metal layer housing, and has a metallic appearance with an aesthetic appeal. Therefore, the electronic device in this application also has the advantages of the metal-layer housing and the non-metal layer housing, and has a metallic appearance with an aesthetic appeal.

## Claims

1. A housing structure, comprising an appearance effect layer (01), a metal layer (02), a connection layer (03), and a non-metal layer (04) that are laminated, wherein
the connection layer (03) is configured to bind the metal layer (02) and the non-metal layer (04); and
the appearance effect layer (01) is formed after surface processing is performed on the metal layer (02); wherein the connection layer (03) comprises a first connection layer (031) and a second connection layer (032), the first connection layer (031) is located on a side close to the metal layer (02), and the second connection layer (032) is located on a side close to the non-metal layer (04);
and **characterized in that**
a binding force of a material of the first connection layer (031) and the metal layer (02) is greater than a binding force of a material of the second connection layer (032) and the metal layer (02), and a binding force of the material of the second connection layer (032) and the non-metal layer (04) is greater than a binding force of the material of the first connection layer (031) and the non-metal layer (04).

2. The housing structure according to claim 1, wherein a contact area proportion of the first connection layer (031) and the metal layer (02) is greater than or equal to 90%; and
a contact area proportion of the second connection layer (032) and the non-metal layer (04) is greater than or equal to 90%.

3. The housing structure according to any one of claims 1 and 2, wherein the first connection layer (031) comprises a first glue layer (0311), and the second connection layer (032) comprises a second glue layer (0321).

4. The housing structure according to claim 3, wherein a material of the first glue layer (0311) comprises epoxy resin glue, and a material of the second glue layer (0321) comprises polyurethane glue.

5. The housing structure according to any one of claims 1 and 2, wherein the first connection layer (031) comprises a solder layer (0312), the second connection layer (032) comprises an electroplated coating (0322), and the electroplated coating is formed by electroplating metal on the non-metal layer (04).

6. The housing structure according to claim 5, wherein a material of the electroplated coating (0322) comprises at least one of tin, chromium, nickel, silver, and copper.

7. The housing structure according to claim 5, wherein a material of the solder layer (0312) comprises a tin-based solder.

8. The housing structure according to any one of claims 1 and 2, wherein the first connection layer (031) comprises a micro-nano porous layer (0313), and the micro-nano porous layer (0313) is formed after micro-nano pore etching processing is performed on the metal layer (02); and
the second connection layer (032) comprises a glue layer (0323).

9. The housing structure according to claim 8, wherein a material of the glue layer (0323) is formed by mixing two types of resin glue.

10. The housing structure according to any one of claims 1 and 2, wherein the first connection layer (031) comprises a micro-nano porous layer (0314), and the micro-nano porous layer (0314) is formed after micro-nano pore etching processing is performed on the metal layer (02); and
the second connection layer (032) comprises a surface pore filling layer (0324), and a material of the surface pore filling layer (324) is the same as a material of the non-metal layer (04).

11. The housing structure according to any one of claims 1 to 10, wherein a thickness of the metal layer (02) occupies 15% to 30% of a total thickness of the housing structure; and
a thickness of the non-metal layer (04) occupies 60% to 80% of the total thickness of the housing structure.

12. The housing structure according to any one of claims 1 to 10, wherein a thickness of the connection layer (03) occupies 2% to 20% of a total thickness of the housing structure.

13. The housing structure according to any one of claims 1 to 10, wherein a material of the metal layer (02) comprises at least one of a magnesium alloy, an aluminum alloy, a titanium alloy, steel, and an amorphous alloy.

14. An electronic device, comprising a circuit board and the housing structure according to any one of claims 1 to 13, wherein the housing structure is located on an outer side of the circuit board.

## Patentansprüche

1. Gehäusestruktur, umfassend eine Erscheinungseffektschicht (01), eine Metallschicht (02), eine Verbindungsschicht (03) und eine Nichtmetallschicht (04), die laminiert sind, wobei die Verbindungsschicht (03) dazu konfiguriert ist, die Metallschicht (02) und die Nichtmetallschicht (04) zu binden; und
die Erscheinungseffektschicht (01) ausgebildet wird, nachdem eine Oberflächenbearbeitung auf der Metallschicht (02) durchgeführt worden ist;
wobei die Verbindungsschicht (03) eine erste Verbindungsschicht (031) und eine zweite Verbindungsschicht (032) umfasst, sich die erste Verbindungsschicht (031) auf einer Seite nahe der Metallschicht (02) befindet und sich die zweite Verbindungsschicht (032) auf einer Seite nahe der Nichtmetallschicht (04) befindet;
und **dadurch gekennzeichnet, dass**
eine Bindungskraft eines Materials der ersten Verbindungsschicht (031) und der Metallschicht (02) größer als eine Bindungskraft eines Materials der zweiten Verbindungsschicht (032) und der Metallschicht (02) ist und eine Bindungskraft des Materials der zweiten Verbindungsschicht (032) und der Nichtmetallschicht (04) größer als eine Bindungskraft des Materials der ersten Verbindungsschicht (031) und der Nichtmetallschicht (04) ist.

2. Gehäusestruktur nach Anspruch 1, wobei ein Kontaktflächenanteil der ersten Verbindungsschicht (031) und der Metallschicht (02) größer als oder gleich 90 % ist; und
ein Kontaktflächenanteil der zweiten Verbindungsschicht (032) und der Nichtmetallschicht (04) größer als oder gleich 90 % ist.

3. Gehäusestruktur nach einem der Ansprüche 1 und 2, wobei die erste Verbindungsschicht (031) eine erste Leimschicht (0311) umfasst und die zweite Verbindungsschicht (032) eine zweite Leimschicht (0321) umfasst.

4. Gehäusestruktur nach Anspruch 3, wobei ein Material der ersten Leimschicht (0311) einen Epoxidharzleim umfasst und ein Material der zweiten Leimschicht (0321) einen Polyurethanleim umfasst.

5. Gehäusestruktur nach einem der Ansprüche 1 und 2, wobei die erste Verbindungsschicht (031) eine Lotschicht (0312) umfasst, die zweite Verbindungsschicht (032) eine galvanische Beschichtung (0322) umfasst und die galvanische Beschichtung durch Galvanisieren von Metall auf der Nichtmetallschicht (04) ausgebildet wird.

6. Gehäusestruktur nach Anspruch 5, wobei ein Material der galvanischen Beschichtung (0322) mindestens eines von Zinn, Chrom, Nickel, Silber und Kupfer umfasst.

7. Gehäusestruktur nach Anspruch 5, wobei ein Material der Lotschicht (0312) ein Lot auf Zinnbasis umfasst.

8. Gehäusestruktur nach einem der Ansprüche 1 und 2, wobei die erste Verbindungsschicht (031) eine mikro-nanoporöse Schicht (0313) umfasst und die mikro-nanoporöse Schicht (0313) ausgebildet wird, nachdem eine Ätzverarbeitung der Mikro-Nanoporen auf der Metallschicht (02) durchgeführt worden ist; und
die zweite Verbindungsschicht (032) eine Leimschicht (0323) umfasst.

9. Gehäusestruktur nach Anspruch 8, wobei ein Material der Leimschicht (0323) durch Mischen zweier Arten von Harzleim ausgebildet wird.

10. Gehäusestruktur nach einem der Ansprüche 1 und 2, wobei die erste Verbindungsschicht (031) eine mikro-nanoporöse Schicht (0314) umfasst und die mikro-nanoporöse Schicht (0314) ausgebildet wird, nachdem eine Ätzverarbeitung der Mikro-Nanoporen auf der Metallschicht (02) durchgeführt worden ist; und
die zweite Verbindungsschicht (032) eine oberflächenporenfüllende Schicht (0324) umfasst und ein Material der oberflächenporenfüllenden Schicht (324) das gleiche wie ein Material der Nichtmetallschicht (04) ist.

11. Gehäusestruktur nach einem der Ansprüche 1 bis 10, wobei eine Dicke der Metallschicht (02) 15 % bis 30 % einer Gesamtdicke der Gehäusestruktur einnimmt; und
eine Dicke der Nichtmetallschicht (04) 60 % bis 80 % der Gesamtdicke der Gehäusestruktur einnimmt.

12. Gehäusestruktur nach einem der Ansprüche 1 bis 10, wobei eine Dicke der Verbindungsschicht (03) 2 % bis 20 % einer Gesamtdicke der Gehäusestruktur einnimmt.

13. Gehäusestruktur nach einem der Ansprüche 1 bis 10, wobei ein Material der Metallschicht (02) mindestens eines von einer Magnesiumlegierung, einer Aluminiumlegierung, einer Titanlegierung, Stahl und einer amorphen Legierung umfasst.

14. Elektronische Vorrichtung, umfassend eine Leiterplatte und die Gehäusestruktur nach einem der Ansprüche 1 bis 13, wobei sich die Gehäusestruktur auf einer Außenseite der Leiterplatte befindet.

## Revendications

1. Structure de logement, comprenant une couche à effet d'apparence (01), une couche métallique (02), une couche de connexion (03) et une couche non métallique (04) qui sont stratifiées, dans laquelle
la couche de connexion (03) est configurée pour lier la couche métallique (02) et la couche non métallique (04) ; et
la couche à effet d'apparence (01) est formée après que le traitement de surface a été effectué sur la couche métallique (02) ;
dans laquelle la couche de connexion (03) comprend une première couche de connexion (031) et une seconde couche de connexion (032), la première couche de connexion (031) est située sur un côté proche de la couche métallique (02), et la seconde couche de connexion (032) est située sur un côté proche de la couche non métallique (04) ;
et **caractérisée en ce que**
une force de liaison d'un matériau de la première couche de connexion (031) et de la couche métallique (02) est supérieure à une force de liaison d'un matériau de la seconde couche de connexion (032) et de la couche métallique (02), et une force de liaison du matériau de la seconde couche de connexion (032) et de la couche non métallique (04) est supérieure à une force de liaison du matériau de la première couche de connexion (031) et de la couche non métallique (04).

2. Structure de logement selon la revendication 1, dans laquelle une proportion de surface de contact de la première couche de connexion (031) et de la couche métallique (02) est supérieure ou égale à 90 % ; et
une proportion de surface de contact de la seconde couche de connexion (032) et de la couche non métallique (04) est supérieure ou égale à 90 %.

3. Structure de logement selon l'une quelconque des revendications 1 et 2, dans laquelle la première couche de connexion (031) comprend une première couche de colle (0311), et la seconde couche de connexion (032) comprend une seconde couche de colle (0321).

4. Structure de logement selon la revendication 3, dans laquelle un matériau de la première couche de colle (0311) comprend de la colle de résine époxy, et un matériau de la seconde couche de colle (0321) comprend de la colle de polyuréthane.

5. Structure de logement selon l'une quelconque des revendications 1 et 2, dans laquelle la première couche de connexion (031) comprend une couche de soudure (0312), la seconde couche de connexion (032) comprend un revêtement électrolytique (0322), et le revêtement électrolytique est formé par électrodéposition de métal sur la couche non métallique (04) .

6. Structure de logement selon la revendication 5, dans laquelle un matériau du revêtement électrolytique (0322) comprend au moins l'un de l'étain, du chrome, du nickel, de l'argent et du cuivre.

7. Structure de logement selon la revendication 5, dans laquelle un matériau de la couche de soudure (0312) comprend une soudure à base d'étain.

8. Structure de logement selon l'une quelconque des revendications 1 et 2, dans laquelle la première couche de connexion (031) comprend une couche micro-nano poreuse (0313), et la couche micro-nano poreuse (0313) est formée après qu'un traitement de gravure de micro-nano pores a été effectué sur la couche métallique (02) ; et
la seconde couche de connexion (032) comprend une couche de colle (0323).

9. Structure de logement selon la revendication 8, dans laquelle un matériau de la couche de colle (0323) est formé en mélangeant deux types de colle de résine.

10. Structure de logement selon l'une quelconque des revendications 1 et 2, dans laquelle la première couche de connexion (031) comprend une couche micro-nano poreuse (0314), et la couche micro-nano poreuse (0314) est formée après qu'un traitement de gravure de micro-nano pores a été effectué sur la couche métallique (02) ; et
la seconde couche de connexion (032) comprend une couche de remplissage de pores de surface (0324), et un matériau de la couche de remplissage de pores de surface (324) est le même qu'un matériau de la couche non métallique (04).

11. Structure de logement selon l'une quelconque des revendications 1 à 10, dans laquelle une épaisseur de la couche métallique (02) occupe 15 % à 30 % d'une épaisseur totale de la structure de logement ; et
une épaisseur de la couche non métallique (04) occupe 60 % à 80 % de l'épaisseur totale de la structure de logement.

12. Structure de logement selon l'une quelconque des revendications 1 à 10, dans laquelle une épaisseur de la couche de connexion (03) occupe 2 % à 20 % d'une épaisseur totale de la structure de logement.

13. Structure de logement selon l'une quelconque des revendications 1 à 10, dans laquelle un matériau de la couche métallique (02) comprend au moins l'un d'un alliage de magnésium, d'un alliage d'aluminium, d'un alliage de titane, d'acier et d'un alliage amorphe.

14. Dispositif électronique, comprenant une carte de circuit imprimé et la structure de logement selon l'une quelconque des revendications 1 à 13, dans lequel la structure de logement est située sur un côté externe de la carte de circuit imprimé.
